# EUROPEAN PATENT APPLICATION

(11) **EP 1 860 503 A2**
(43) Date of publication of application: **28.11.2007**
(21) Application number: 07010359.3
(22) Date of filing: 24.05.2007
(51) Int. Cl.: G03F 7/00

(54) **Colored photosensitive resin composition, color filter, image sensor, and camera system**

(30) Priority: 24.05.2006 JP 2006143553
(71) Applicant: Sumitomo Chemical Company, Limited, Tokyo 104-8260 (JP); Sony Corporation, Minato-ku Tokyo 108-0075 (JP)
(72) Inventor: Miya, Yoshiko, Minami-ku, Kyoto-shi, Kyoto (JP); Maeda, Kensaku, Tokyo (JP); Harasawa, Masanori, Tokyo (JP); Ootsuka, Yoichi, Tokyo (JP)
(74) Representative: Vossius & Partner

(57) **Abstract**

The present invention provides a colored photosensitive resin composition which causes a small change in exposure when a pattern is subjected to projection exposure.
Disclosed is a colored photosensitive resin composition comprising a dye, a photo acid generator, a curing agent, an alkali-soluble resin, a solvent, and a compound represented by the formula (1): 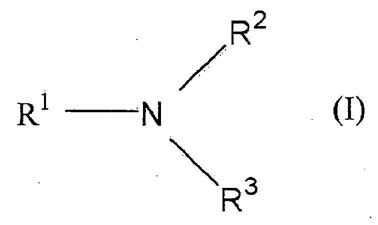 in the formula (I), R¹ to R³ each independently represents a hydrogen atom, a linear alkyl group having 1 to 6 carbon atoms, a branched alkyl group having 3 to 12 carbon atoms, a cycloalkyl group having 3 to 6 carbon atoms or an aryl group having 6 to 12 carbon atoms, and a hydrogen atom on the linear alkyl group having 1 to 6 carbon atoms, a hydrogen atom on the branched alkyl group having 3 to 12 carbon atoms, a hydrogen atom on the cycloalkyl group and a hydrogen atom on the aryl group may be substituted with a hydroxyl group, provided that at least one of R¹ to R³ represents a group other than a hydrogen atom.

## Description

The present application has been filed claiming the Paris Convention priority based on the Japanese patent application No. 2006-143553 (filed on May 24, 2006, entitled "COLORED PHOTOSENSITIVE RESIN COMPOSITION, COLOR FILTER, IMAGE SENSOR, AND CAMERA SYSTEM"), and a whole of the descriptions of the application are herein fully incorporated in the description of the present specification by reference.
The present invention relates to a colored photosensitive resin composition, a color filter, an image sensor, and a camera system.

An image sensor used in digital cameras and digital video devices comprises a color filter.
As a method for producing a color filter, there have hitherto been developed various methods for producing a color filter by a photolithography method using a photosensitive resin composition prepared by mixing a photosensitive resin composition typified by photoresist with coloring materials such as pigments and dyes (see, for example, Japanese Unexamined Patent Publication (Kokai) No. 2-127602, page 6, lower right column, line 15 to page 25, lower left column, line 14; Japanese Unexamined Patent Publication (Kokai) No. 4-283701, page 2, right column, line 38 to page 3, right column, line 43; and Japanese Unexamined Patent Publication (Kokai) No. 2002-14220, page 3, right column, line 19 to page 11, right column, line 15).
The above methods make it possible to form a color filter as an aggregate of pixels, each being colored in three primary colors of light (red color, green color, and blue color) with coloring materials such as pigments and dyes.

A colored photosensitive resin composition containing a conventionally known dye had the problem that the exposure required when a pattern is subjected to projection exposure after storage of the composition remarkably changes as compared with the exposure before storage. Therefore, the colored photosensitive resin composition using the dye had the problem that it became impossible to form pixels in an expected exposure.
An object of the present invention is to provide a colored photosensitive resin composition which causes only a small change in exposure in case of forming a pattern using the composition before and after storage of the colored photosensitive resin composition; a color filter produced using the colored photosensitive resin composition; an image sensor comprising the color filter; and a camera system comprising the image sensor.

The present inventors have intensively studied so as to solve the above problems and found that, in a colored photosensitive resin composition containing a dye including a specific compound, a change in exposure decreases when a pattern is subjected to projection exposure before and after storage of the composition.
That is, the present invention provides a colored photosensitive resin composition comprising a dye, a photo acid generator, a curing agent, an alkali-soluble resin, a solvent, and a compound represented by the formula (I) :

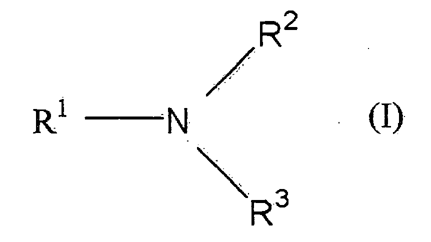

In the formula (I), R¹ to R³ each independently represents a hydrogen atom, a linear alkyl group having 1 to 6 carbon atoms, a branched alkyl group having 3 to 12 carbon atoms, a cycloalkyl group having 3 to 6 carbon atoms or an aryl group having 6. to 12 carbon atoms, and a hydrogen atom on the linear alkyl group having 1 to 6 carbon atoms, a hydrogen atom on the branched alkyl group having 3 to 12 carbon atoms, a hydrogen atom on the cycloalkyl group and a hydrogen atom on the aryl group may be substituted with a hydroxyl group, provided that at least one of R¹ to R³ represents a group other than a hydrogen atom.

Also, the present invention provides a color filter produced by using the colored photosensitive resin composition, an image sensor comprising the color filter, and a camera system comprising the image sensor.

In the colored photosensitive resin composition of the present invention, when a pattern is subjected to projection exposure after storage of the composition, the exposure does not change remarkably after storage of the composition as compared with the exposure of the composition before storage, and therefore an image sensor and a camera system can be stably produced.
Fig. 1 shows a cross section structure of a CCD image sensor.
Fig. 2 shows a procedure of a method for producing a color filter array.
Fig. 3 shows a procedure of a method for producing a color filter array.
Fig. 4 shows a procedure of a method for producing a color filter array.
Fig. 5 shows a procedure of a method for producing a color filter array.
Fig. 6 shows a procedure of a method for producing a color filter array.
Fig. 7 shows a procedure of a method for producing a color filter array.
Fig. 8 shows a cross section structure of a CMOS image sensor.

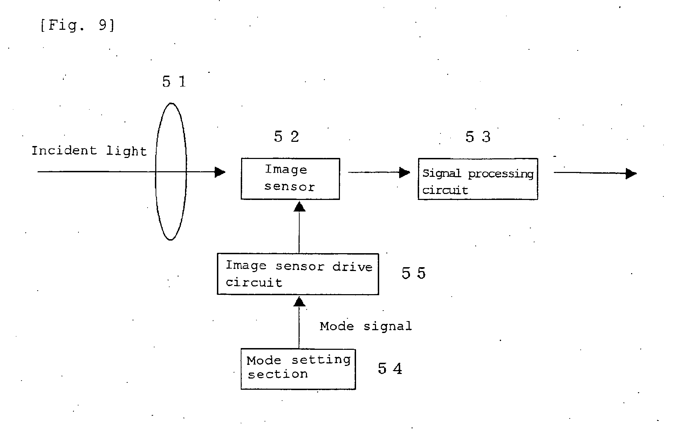

Fig. 9 shows a block diagram of a camera system.

### [Brief Description of the Reference Symbols]

- 1:: Silicon substrate
- 2, 32:: Photodiode
- 3:: Vertical charge transfer section
- 4:: Vertical charge transfer electrode
- 5, 37:: Insulation film
- 6:: Light shielding film
- 7, 36:: BPSG film
- 8, 38:: P-SiN film
- 9, 39:: Flattened film (1)
- 10, 40:: Color filter array
- 10G, 40G:: Green color pixel pattern
- 10R, 40R:: Red color pixel pattern
- 10B, 40B:: Blue color pixel pattern
- 11, 41:: Flattened film (2)
- 12; 42 :: Microlens array
- 13:: Photomask
- 14:: Exposed area
- 15:: Unexposed area
- 31:: Well
- 33:: Impurity diffusion layer
- 34:: Electrode
- 35:: Wiring layer

The present invention will now be described in detail.

The colored photosensitive resin composition of the present invention contains a dye. The dye is a dye which has sufficient solubility in a solvent of the colored photosensitive resin composition and has sufficient solubility in a developing solution in the developing step upon formation of a pattern, and can also form a color filter pattern.
Such a dye can be selected from among various oil-soluble dyes, direct dyes, and acid dyes.
Examples of the dye includes
C.I.Solvent Yellow 4, C.I.Solvent Yellow 14, C.I.Solvent Yellow 15, C.I.Solvent Yellow 24 and C.I.Solvent Yellow 82,
C.I.Solvent Yellow 94, C.I.Solvent Yellow 98, and C.I.Solvent Yellow 162;
C.I. Solvent Red 45 and C.I. Solvent Red 49;
C.T. Solvent Orange 2, C.I.Solvent Orange 7, C.I.Solvent Orange 11, C.I.Solvent Orange 15, C.I.Solvent Orange 26, and
C.I.Solvent Orange 56;
C.I.Solvent Blue 35, C.I.Solvent Blue 37, C.I.Solvent Blue 59, and C.I.Solvent Blue 67;
C.I.Acid Yellow 17, C.I.Acid Yellow 29, C.I.Acid Yellow 40, and C.I.Acid Yellow 76;
C.I.Acid Red 91, C.I.Acid Red 92, C.I.Acid Red 97, C.I.Acid Red 114, C.I.Acid Red 138, and C.I.Acid Red 151;
C.I.Acid Orange 51 and C.I.Acid Orange 63;
C.I.Acid Blue 80, C.I.Acid Blue 83, and C.I.Acid Blue 90;
C.I.Acid Green 9, C.I.Acid Green 16, C.I.Acid Green 25; and
C.I.Acid Green 27; and are preferably
C.I.Solvent Yellow 82'and C.I.Solvent Yellow 162;
C.I.Solvent Red 45 and C.I.Solvent Red 49;
C.I.Solvent Orange 56;
C.I.Solvent Blue 67;
C.I.Acid Blue 90;
C.I.Acid Green 9 and C.I.Acid Green 16; and
C.I.Basic Red 1.

As the dye of the colored photosensitive resin composition of the present invention, for example, it is also possible to use amine salts of acid dyes represented by the formulas (i) to (vii) and sulfonamide compounds of acid dyes represented by the formulas (viii) to (ix):

D-(SO₃⁻)ₘ(CₙH₂ₙ₊₁N⁺H₃)ₘ (i)

D-(SO₃⁻)ₘ{(CₙH₂ₙ₊₁)₂N⁺H₂}ₘ (ii)

D-(SO₃⁻)ₘ{(CₙH₂ₙ₊₁)₃N⁺H}ₘ (iii)

D-(SO₃⁻)m{(CₙH₂ₙ₊₁)₄N⁺}ₘ (iv)

D-(SO₃⁻)ₘ(CₑH₂ₑ₊₁OC_{f}H_{2f}N⁺H₃)ₘ (v)

D-(SO₃⁻)ₘ{(CₙH₂ₙ₊₁)(PhCH₂)₂N⁺H}ₘ (vi)

D-(SO₃⁻)m{(CₙH₂ₙ₊₁)Py⁺}ₘ (vii)

D-[{SO₂NH(CₙH₂ₙ₊₁)}ₚ][(SO₃L)_{q}] (viii)

D-[{SO₂NH(CₑH₂ₑ₊₁OC_{f}H_{2f})}ₚ][(SO₃L)_{q}] (ix)

In the formulas (i) to (ix), D represents a coloring material matrix;
m represents an integer of 1 or more and 20 or less;
n represents an integer of 1 or more and 20 or less;
e and f each independently represents an integer of 1 or more and 10 or less;
Ph represents a phenyl group;
Py represents a pyridine ring residue or a methylpyridine ring residue, which is attached to CₙH₂ₙ₊₁ through a nitrogen atom;
p represents an integer of 1 or more and 8 or less;
q represents an integer of 0 or more and 8 or less; and
L represents a hydrogen atom or a monovalent cation.

Specific examples of the coloring material matrix D include azo dye matrix, xanthene dye matrix, arithraquinone dye matrix, triphenylmethane dye matrix, methine dye matrix, cyanine dye matrix, and phthalocyanine dye matrix.
m preferably represents an integer of 1 or more and 10 or less, and more preferably an integer of 1 or more and 8 or less.
n preferably represents an integer of 1 or more and 10 or less, and more preferably an integer of 1 or more and 8 or less.
e and f each independently represents preferably an integer of 1 or more and 8 or less, and more preferably an integer of 1 or more and 6 or less.
Py preferably represents a methylpyridine ring residue.
p preferably represents an integer of 1 or more and 6 or less, and more preferably an integer of 1 or more and 5 or less.
q preferably represents an integer of 0 or more and 6 or less, and more preferably an integer of 0 or more and 5 or less.
Examples of the monovalent cation represented by L include sodium atom, potassium atom, and quaternary ammonium ion such as (C₂H₅)₃HN⁺.

It is possible to use, as the dye, dyes represented by the formulas (21) to (32).

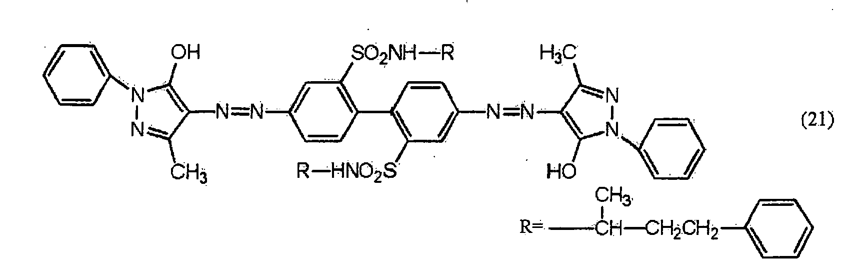

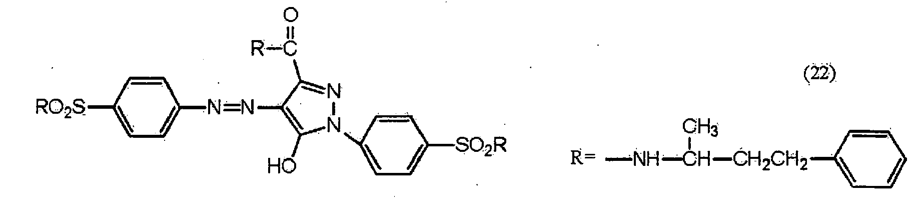

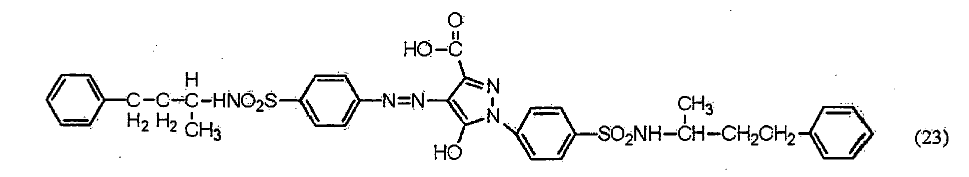

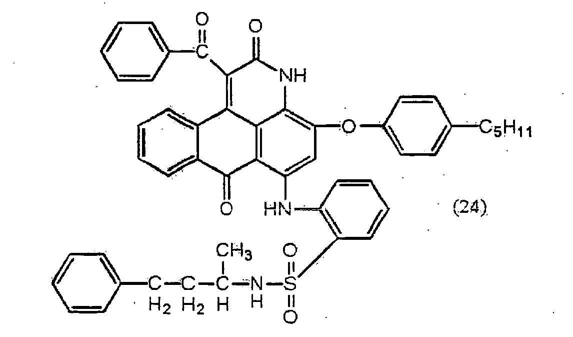

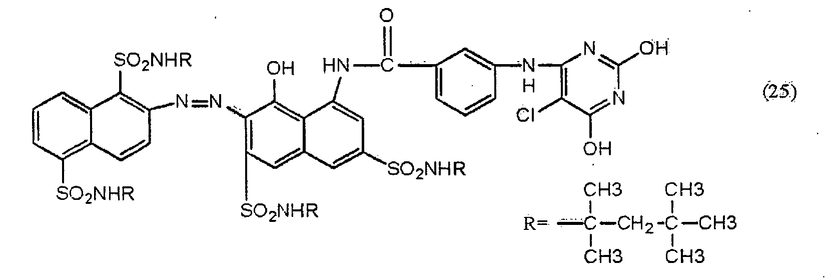

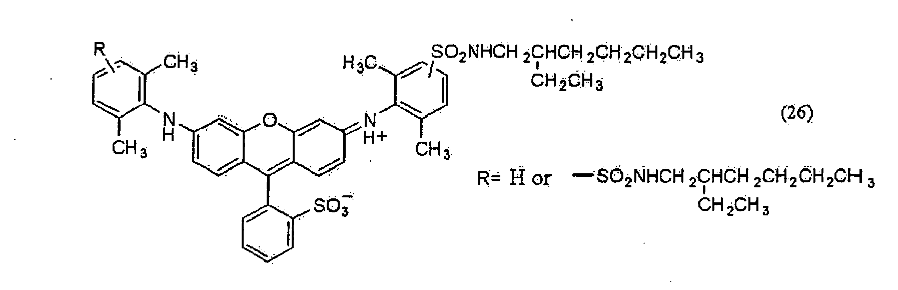

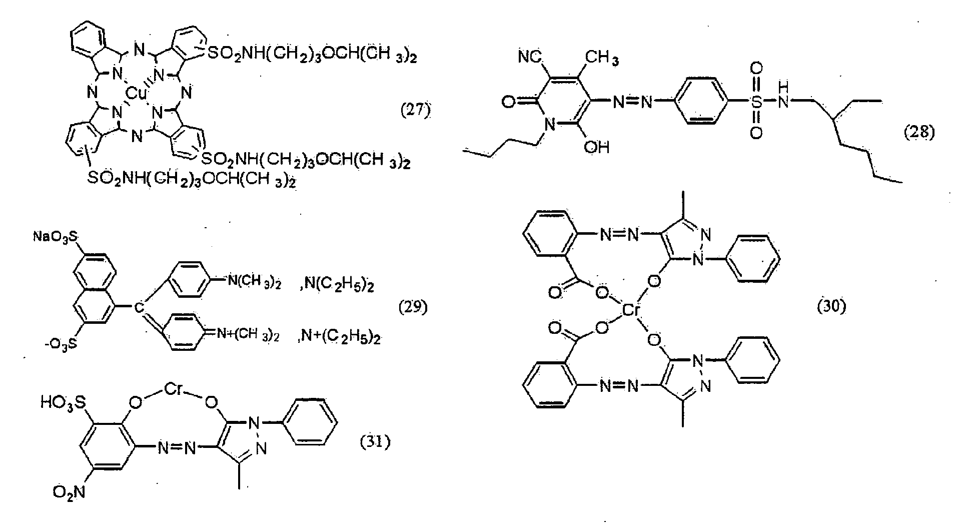

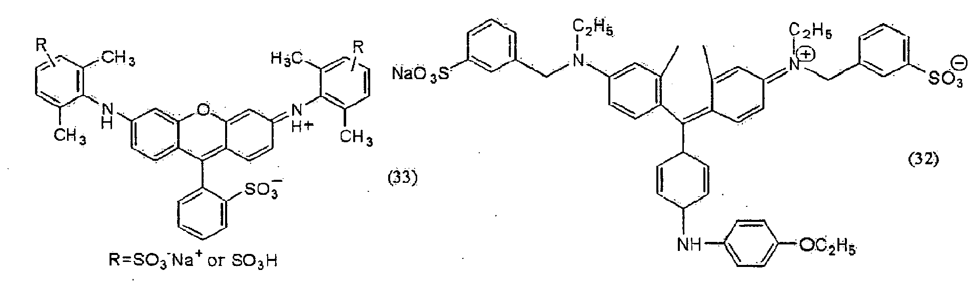

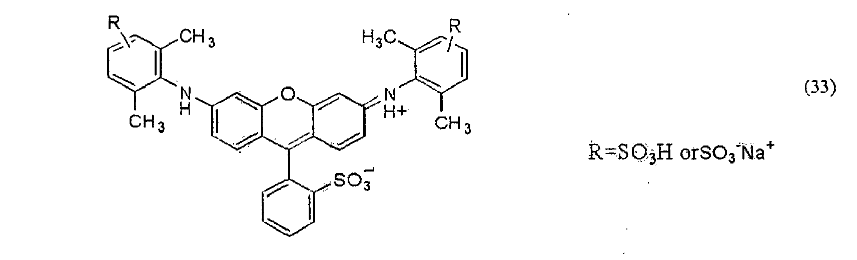

As a combination of dyes used in the colored photosensitive resin composition of the present invention, for example, a combination of a dye represented by the formula (13), a dye represented by the formula (24), and a dye represented by the formula (25) can be preferably selected so as to form a red color filter.
To form a blue color filter, for example, a combination of a dye represented by the formula (25), C.I.Acid Blue 90, and C.I.Solvent Blue 67 can be preferably selected.
To form a green color filter, for example, a combination of C.I.Solvent Blue 67, C.I. Acid Green 9, C.I.Acid Green 16, C.I.Solvent Yellow 82, and C.I.Solvent Yellow 162 can be preferably selected.
To form a yellow color filter, for example, a combination of C.I.Solvent Yellow 82 and C.I.Solvent Yellow 162 can be preferably selected.
The combination of red, green, blue, and yellow dyes is not limited to the above combinations, and the respective dyes can be appropriately used in combination according to an optical spectrum of the objective color filter.

The content of the dye is preferably from 20 to 80% by mass, more preferably from 25 to 75% by mass, and particularly preferably from 35 to 60% by mass, based on the solid content of the colored photosensitive resin composition. As used herein, the solid content of the colored photosensitive resin composition means the total amount excluding the solvent from the composition.
The content of the dye is preferably within the above range because the resulting color filter has high color density and dissolution contrast to a developing solution upon patterning increases.

The colored photosensitive resin composition of the present invention contains a photo acid generator. As the photo acid generator, for example, it is possible to use iodonium salt compounds, sulfonium salt compounds, organic halogen compounds (haloalkyl-s-triazine compounds), sulfonate ester compounds, disulfone compounds, diazomethanesulfonyl compounds, N-sulfonyloxyimide compounds, and oxime-based compounds. These compounds can be used alone or in combination, if necessary. More specific examples of the photo acid generator include the following compounds.

### Iodonium salt compounds

diphenyliodonium trifluoromethanesulfonate, 4-methoxyphenylphenyliodonium hexafluoroantimonate, 4-methoxyphenylphenyliodonium trifluoromethanesulfonate, bis(4-tert-butylphenyl)iodonium tetrafluoroborate, bis(4-tert-butylphenyl)iodonium hexafluorophosphate, bis (4-tert-butylphenyl) iodonium hexafluoroantimonate, bis (4-tert-butylphenyl) iodonium trifluoromethanesulfonate, bis (4-tert-butylphenyl) iodonium 10-camphorsulfonate, bis (4-tert-butylphenyl) iodonium, p-toluenesulfonate, and the like

### Sulfonium salt compounds

triphenylsulfonium hexafluorophosphate, triphenylsulfonium hexafluoroantimonate, triphenylsulfonium trifluoromethanesulfonate, 4-methoxyphenyldiphenylsulfonium hexafluoroantimonate, 4-methoxyphenyldiphenylsulfonium trifluoromethanesulfonate, 4-methylphenyldiphenylsulfonium methanesulfonate, p-tolyldiphenylsulfonium trifluoromethanesulfonate, 2,4,6-trimethylphenyldiphenylsulfonium trifluoromethanesulfonate, 4-tert-butylphenyldiphenylsulfonium trifluoromethanesulfonate, 4-phenylthiophenyldiphenylsulfonium hexafluorophosphate, 4-phenylthiophenyldiphenylsulfonium hexafluoroantimonate, 1-(2-naphthoylmethyl)thiolanium hexafluoroantimonate, 1-(2-naphthoylmethyl)thiolanium trifluoromethanesulfonate, 4-hydroxy-1-naphthyldimethylsulfonium hexafluoroantimonate, 4-hydroxy-1-naphthyldimethylsulfonium trifluoromethanesulfonate, and the like

### Organic halogen compounds

2-methyl-4,6-bis(trichloromethyl)-13,5-triazine, 2,4,6-tris(trichloromethyl)-1,3,5-triazine, 2-phenyl-4,6-bis(trichlotomethyl)-1,3,5-triazine, 2-(4-chlorophenyl)-4,6-bis(trichloromethyl)-1,3,5-triazine, 2-(4-methoxyphenyl)-4,6-bis (trichloromethyl)-1,3,5-triazine, 2-(4=methoxy-1-naphthyl)-4,6-bis(trichloromethyl)-1,3,5-triazine, 2-(benzo[d][1,3]dioxolan-5-yl)-4,6-bis(trichloromethyl)-1,3,5-triazine, 2-(4-methoxystyryl)-4,6-bis(trichloromethyl)-1,3,5-triazine, 2-(3,4,5-trimethoxystyryl)-4,6-bis (trichloromethyl) -1, 3, 5-triazine, 2-(3,4-dimethoxystyryl)-4,6-bis(trichloromethyl)-1,3,5-triazine, 2-(2,4-dimethoxystyryl)-4,6-bis(trichloromethyl)-1,3,5-triazine, 2-(2-methoxystyryl)-4,6-bis(trichloromethyl)-1,3,5-triazine, 2-(4-butoxystyryl)-4,6-bis(trichloromethyl)-1,3,5-triazine, 2-(4-pentyloxystyryl)-4,6-bis(trichloromethyl)-1,3,5-triazine, and the like

### Sulfonate ester compounds

1-benzoyl-1-phenylmethyl p-toluenesulfonate, 2-benzoyl-2-hydroxy-2-phenylethyl p-toluenesulfonate, 1,2,3-benzenetriyl trismethanesulfonate, 2,6-dinitrobenzyl p-toluenesulfonate, 2-nitrobenzyl p-toluenesulfonate, 4-nitrobenzyl p-toluenesulfonate, and the like

### Disulfone compounds

diphenyldisulfone, di-p-tolyl disulfone, and the like

### Diazomethanesulfonyl compounds

bis(phenylsulfonyl)diazomethane, bis (4= chlorophenylsulfonyl)diazomethane, bis(p-tolylsulfonyl)diazomethane, bis(4-tert-butylphenylsulfonyl)diazomethane, bis(2,4= xylylsulfonyl)diazoniethane, bis(cyclohexylsulfonyl)diazomethane, bis(tert-butylsulfonyl)diazomethane, (benzoyl) (phenylsulfonyl)diazomethane, and the like

### N-sulfonyloxyimide compounds

N-(ethylsulfonyloxy)succinimide, N-(isopropylsulfonyloxy)succinimide, N-(butylsulfonyloxy)succinimide, N-(10-camphorsulfonyloxy)succinimide, N-(phenylsulfonyloxy)succinimide, N-(trifluoromethylsulfonyloxy)succinimide, N-(trifluoromethylsulfonyloxy)phthalimide, N-(trifluoromethylsulfonyloxy)-5-norbornene-2,3-dicarboxyimide, N-(trifluoromethylsulfonyloxy)naphthalimide, N-(10-camphorsulfonyloxy)naphthalimide, and the like

### Oxime-based compounds

α-(4-toluenesulfonyloxyimino)benzylcyanide, α-(4-toluenesulfonyloxyimino)-4-methoxybenzylcyanide, α-(camphorsulfohyloxyimino)-4-methoxybenzylcyanide, α-trifluoromethahesulfonyloxyimino-4-methoxybenzylcyanide, α-(1-hexanesulfonyloxyimino-4-methoxybenzylcyanide, α-naphthalenesulfonyloxyimino-4-methoxybenzylcyanide, α-(4-toluenesulfonylokyimino)-4-N-diethylanilylcyanide, α-(4-toluenesulfonyloxyimino)-3,4-dimethoxybenzylcyanide, α-(4-toluenesulfonyloxyimino)-4-thienylcyanide, (5-tosyloxyimino-5H-thiophen-2-ylidene)-(2-methylphenyl)acetonitrile, (5-camphorsulfonyloxyimino-5H-thiophen-2-ylidene)-(2-methylphenyl)acetonitrile, (5-n-propyloxyimino-5H-thiophen-2-ylidene)-(2-methylphenyl)acetonitrile, (5-n-octyloxyimino-5-camphorsulfonyloxyimino-5H-thiophen-2-ylidene)-(2-methylphenyl)acetonitrile, and the like

When i-ray and g-ray are used as an exposure light source, an oxime compound is preferably used as the photo acid generator because exposure can be conducted without generating a volatile component. It is particularly preferred to use α-(4-toluenesulfonyloxyimino)-4-methoxybenzylcyanide, α-(camphorsulfonyloxyimino)-4-methoxybenzylcyanide, α-(4-toluenesulfonyloxyimino)-4-thienylcyanide, (5-camphorsulfonyloxyimino-5H-thiophen-2-ylidene)-(2-methylphenyl)acetonitrile, or (5-n-propylsulfonyloxyimino-5H-thiophen-2-ylidene)-(2-methylphenyl)acetonitrile because the resulting colored photosensitive resin composition has high sensitivity.

The content of the photo acid generator is preferably from 0.001 to 20% by mass, more preferably from 0.5 to 10% by mass, and particularly preferably from 2 to 8% by mass, based on the solid content of the colored photosensitive resin composition. The content of the photo acid generator is preferably within the above range because the exposure decreases in case of forming a pattern by a photolithography method and also dissolution contrast between the exposed area and the unexposed area upon development increases.

The colored photosensitive resin composition of the present invention contains a curing agent: As the curing agent, a compound capable of curing by heating is used. The curing agent includes, for example, a compound represented by the formula (II):

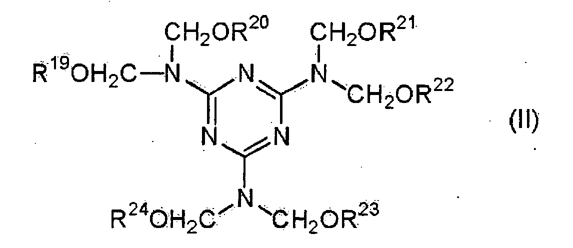

In the formula (II), R¹⁹ to R²⁴ each independently represents a hydrogen atom, a linear alkyl group having 1 to 10 carbon atoms, or a branched alkyl group having 3 to 10 carbon atoms, provided that at least two of them are not hydrogen atoms.

Examples of the linear alkyl group having 1 to 10 carbon atoms include a methyl group, ethyl group, n-propyl group, n-butyl group, n-pentyl group, n-hexyl group, n-heptyl group, n-octyl group, n-nonyl group, and n-decyl, and are preferably methyl group, ethyl group, n-propyl group, and n-butyl group.
Examples of the branched alkyl group having 3 to 10 carbon atoms include an isopropyl group, isobutyl group, sec-butyl group, tert-butyl group; and one of the following groups:

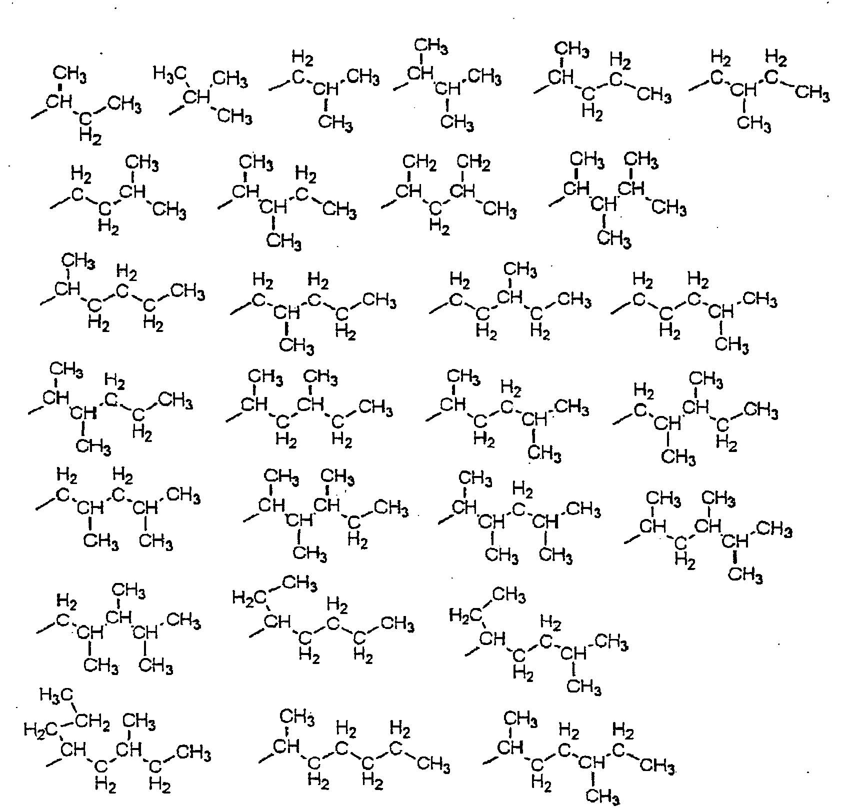

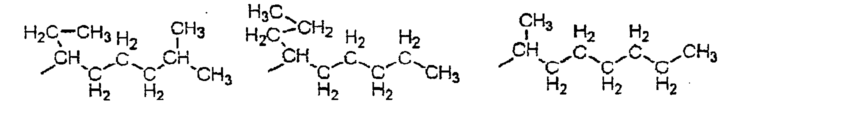

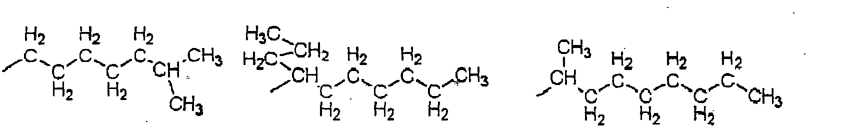

Among them, isopropyl group, isobutyl group, sec-butyl group, and tert-butyl group are preferable.

Examples of the compound represented by the formula (II) include hexamethoxymethylmelamine and hexaethoxymethylmelamine, and preferred is hexamethoxymethylmelamine.

The content of the curing agent is preferably from 10 to 40% by mass, and more preferably from 20 to 30% by mass, based on the solid content of the colored photosensitive resin composition. The content of the curing agent is preferably within the above range because the exposure in case of forming a pattern by a photolithography method decreases, and good pattern shape after the development and sufficient mechanical strength of the pattern after curing the pattern with heating are attained, and also thickness loss of a pixel pattern does not occur in the developing step and thus color unevenness of the image is less likely to occur.

The colored photosensitive resin composition of the present invention contains an alkali-soluble resin. The alkali-soluble resin is not specifically limited as long as it has the property that the unexposed area is dissolved in an alkali developing solution and also the exposed area is not dissolved in the alkali developing solution in the photolithography method. For example, a novolak resin and a polyvinyl resin are used.

Examples of the novolak resin include paracresol novolak resin, metacresol novolak resin, novolak resin of paracresol and metacresol, and novolak resin having a repeating structure represented by the formula (71).

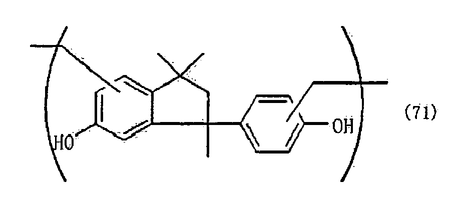

The polystyrene equivalent weight average molecular weight of the novolak resin is preferably from 3,000 to 20,000, more preferably from 5,000 to 18,000, and particularly preferably from 10,000 to 15,000.

The polyvinyl resin includes those containing p-vinylphenol as a polymerization component, particularly a copolymer of styrene and p-vinylphenol. It is preferable to use a copolymer in which hydrogen atoms of a hydroxyl group of p-vinylphenol are partially substituted with an alkyl group having 1 to 6 carbon atoms, because the exposure decreases in case of forming a pattern by a photolithography method and also a pattern thus formed is likely to have a rectangular shape which is preferable for a color filter. The group, with which the hydroxyl group of p-vinylphenol is substituted, is preferably an alkyl group having 1 to 6 carbon atoms and the alkyl group may be branched or may have a cyclic structure. Examples of the alkyl group having 1 to carbon atoms include a methyl group, ethyl group, isopropyl group, isobutyl group, sec-butyl group, tert-butyl group, and cyclohexyl group.

The polystyrene equivalent weight average molecular weight of the polyvinyl resin is preferably from 1,000 to 20,000, more preferably from 2,000 to 18,000, and particularly preferably from 2,000 to 6,000.

The content of the alkali-soluble resin is preferably from 1 to 50% by mass, more preferably from 1 to 40% by mass, and particularly preferably from 5 to 40% by mass, based on the solid content of the colored photosensitive resin composition. The content of the alkali-soluble resin is preferably within the above range because sufficient solubility in a developing solution is attained and thickness loss is less likely to occur in the developing step, and also the exposure decreases in case of forming a pattern by a photolithography method.

The colored photosensitive resin composition of the present invention contains a compound represented by the formula (I). When the colored photosensitive resin composition contains the compound represented by the formula (I), the exposure may not undergo a large change before and after storage of the colored photosensitive resin composition when a photolithography method is conducted using the colored photosensitive resin composition:

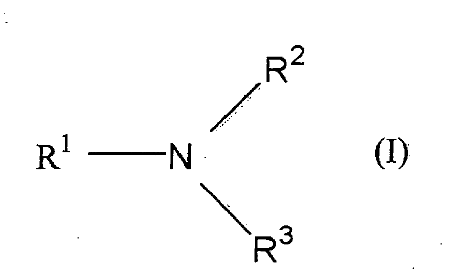

In the formula (I), R¹ to R³ each independently represents a hydrogen atom, a linear alkyl group having 1 to 6 carbon atoms, a branched alkyl group having 3 to 12 carbon atoms, a cycloalkyl group having 3 to 6 carbon atoms or an aryl group having 6 to 12 carbon atoms, and a hydrogen atom on the linear alkyl group having 1 to 6 carbon atoms, a hydrogen atom on the branched alkyl group having 3 to 12 carbon atoms, a hydrogen atom on the cycloalkyl group and a hydrogen atom on the aryl group may be substituted with a hydroxyl group, provided that at least one of R¹ to R³ represents a group other than a hydrogen atom.

Examples of the linear alkyl group having 1 to 6 carbon atoms include a methyl group, ethyl group, n-propyl group, n-butyl group, n-pentyl group, and n-hexyl group, and are preferably methyl group, ethyl group, n-propyl group, and n-butyl group, and more preferably n-butyl group.
Examples of the branched alkyl group having 3 to 6 carbon atoms include an isopropyl group, sec-butyl group, tert-butyl group, and the following groups, and are preferably isopropyl group, sec-butyl group, and tert-butyl group.
Examples of the cycloalkyl group having 3 to 6 carbon atoms include cyclopropyl group, cyclobutyl group, cyclopentyl group, and cyclohexyl group, and are preferably cyclobutyl group, cyclopentyl group, and cyclohexyl group, and more preferably cyclopentyl group and cyclohexyl group.
Examples of the aryl group having 6 to 12 carbon atoms include a phenyl group, benzyl group, and naphthyl group.
Examples of the alkyl group, which may be substituted with the hydroxyl group, include a hydroxymethyl group, 1-hydroxyethyl group, 2-hydroxyethyl group, 1-hydroxy-n-propyl group, 2-hydroxy-n-propyl group, 3-hydroxy-n-propyl group, 1-hydroxy-n-butyl group, 2-hydroxy-n-butyl group, 3-hydroxy-n-butyl group, 4-hydroxy-n-butyl group, 1-hydroxy-1-methylpropyl group, 2-hydroxy-1-methyl-propyl group, 3-hydroxy-1-methyl-propyl group, 1-hydroxymethyl-propyl group, 1-hydroxy-2-methyl-propyl group, 2-hydroxy-2-methyl-propyl group, 3-hydroxy-2-methyl-propyl group, 4-hydroxy-2-methyl-propyl group, 1-hydroxy-n-pentyl group, 2-hydroxy-n-pentyl group, 3-hydroxy-n-pentyl group, 4-hydroxy-n-pentyl group, 5-hydroxy-n-pentyl group, 1-hydroxy-1-methyl-butyl group, 2-hydroxy-1-methyl-butyl group, 3-hydroxy-1-methyl-butyl group, 4-hydroxy-1-methyl-butyl group, 1-hydroxymethyl-butyl group, 1-hydroxy-2-methyl-butyl group, 2-hydroxy-2-methyl-butyl group, 3-hydroxy-2-methyl-butyl group, 4-hydroxy-2-methyl-butyl group, 2-hydroxymethyl-butyl group; 1-hydroxy-3-methyl-butyl group, 2-hydroxy-3-methyl-butyl group, 3-hydroxy-3-methylbutyl group, 4-hydroxy-3-methyl-butyl group, 3-hydroxymethyl-butyl group, 2-hydroxy-1,2-dimethyl-propyl group, 3-hydroxy-1,1-dimethyl-propyl group, 1-hydroxy-2,2-dimethyl-propyl group, 3-hydroxy-2,2-dimethyl-propyl group, 1-hydroxy-n-hexyl group, 2-hydroxy-n-hexyl group, 3-hydroxy-n-hexyl group, 4-hydroxy-n-hexyl group, 5-hydroxy-n-hexyl group, 6-hydroxy-n-hexyl group, 1-hydroxy-1-methyl-pentyl group, 2-hydroxy-1-methyl-pentyl group, 3-hydroxy-1-methyl-pentyl group, 4-hydroxy-1-methyl-pentyl group, 5-hydroxy-1-methyl-pentyl group, 1-hydroxymethyl-pentyl group, 1-hydroxy-2-methylpentyl group, 2-hydroxy-2-methyl-pentyl group, 3-hydroxy-2-methyl-pentyl group, 4-hydroxy-2-methyl-pentyl group, 5-hydroxy-2-methyl-pentyl group, 2-hydroxymethyl-pentyl group, 1-hydroxy-3-methyl-pentyl group, 2-hydroxy-3-methyl-pentyl group, 3-hydroxy-3-methyl-pentyl group, 4-hydroxy-3-methylpentyl group, 5-hydroxy-3-methyl-pentyl group, 3-hydroxymethyl-pentyl group, 1-hydroxy-4-methyl-pentyl group, 2-hydroxy-4-methyl-pentyl group, 3-hydroxy-4-methyl-pentyl group, 4-hydroxy-4-methyl-pentyl group, 5-hydroxy-4-methylpentyl group, 4-hydroxymethyl-pentyl group, 1,1-hydroxymethylmethyl-butyl group, 2-hydroxy-1,1-dimethyl-butyl group, 3-hydroxy-1,1-dimethyl-butyl group, 4-hydroxy-1,1-dimethyl-butyl group, 1-hydroxy-2,2-dimethyl-butyl group, 2,2-hydroxymethylmethyl-butyl group, 3-hydroxy-2,2-dimethylbutyl group, 4-hydroxy-2,2-dimethyl-butyl group, 1-hydroxy-3,3-dimethyl-butyl group, 2-hydroxy-3,3-dimethyl-butyl group, 3,3-hydroxymethylmethyl-butyl group, and 4-hydroxy-3,3-dimethyl-butyl group.
At least one group of R¹ to R³ is preferably substituted with a hydroxyl group.

Specific examples of the compound represented by the formula (I) include N-methylamine, N-ethylamine, N-n-propylamine, N-n-butylamine, N-n-hexylamine, N-cyclohexylamine, N-n-pentylamine, N-n-octylamine, N-n-nonylamine, N-n-decylamine, N,N-dimethylamine, N,N-diethylamine, N,N-methylphenylamine, N,N-methylcyclohexylamine, trimethylamine, triethylamine, methyldiphenylamine, dimethylcyclohexylamine, methylphenylcyclohexylamine, triphenylamine, tri-n-propylamine, triisopropylamine, tri-n-butylamine, triisobutylamine, tri-sec-butylamine, tri-tert-butylamine, tri-n-pentylamine, triisopentylamine, tri-sec-pentylamine, tri-n-hexylamine, tri-sec-hexylamine, tri-tert-hexylamine, tri-n-octylamine, diisobutylamine, N=phenyldiethanolamirie, N-benzylisopropylamine, dibutylamine, dipentylamine, dihexylamine, diheptylamine, dioctylamine, dinonylamine, didecylamine, diphenylamine, trimethylamine, tripropylamine, tributylamine, tripentylamine, trihexylamine, triheptylamine, trioctylamine, trihonylamine, tridecylamine, methyldibutylamine, methyldipentylamine, methyldihexylamine, methyldicyclohexylamine, methyldiheptylamine, methyldioctylamine, methyldinonylamine, methyldidecylamine, ethyldibutylamine, ethyldipentylamine, ethyldihexylamine, ethyldiheptylamine, ethyldioctylamine, ethyldinonylamine, ethyldidecylamine, dicyclohexylmethylamine, tris[2-(2-methoxyethoxy)ethyl]amine 3-amino-ethanol, 2-amino-ethanol, 1-amino-1-propanol, 2-amino-1-propanol, 3-amino-1-propanol, 2-amino-2-propariol, 1-amino-1-butanol, 2-amino-1-butanol, 3-amino-1-butanol, 4-amino-1-butanol, 1-amino-2-butanol, 2-amino-2-butanol, 3-amino-2-butanol, 4-amino-2-butanol, 1-amino-2-methyl-1-propanol, 2-amino-2-methyl-1-propanol, 3-amino-2-methyl-1-propanol, 2-aminomethyl-1-ptopanol, 1-amino-1-pentanol, 2-amino-1-pentanol, 3-amino-1-pentanol, 4-amino-1-pentanol, 5-amino-1-pentanol, 1,-amino-2-pentanol, 2-amino-2-pentanol, 3-amino-2-pentanol, 4-amino-2-pentanol, 5-amino-2-pentanol, 1-amino-3-pentanol, 2-amino-3-pentanol, 3-amino-3-pentanol, 4-amino-3-pentanol, 5-amino-3-pentanol, 1-amino-2-methyl-1-butanol, 2-amino-2-methyl-1-butanol, 3-amino-2-methyl-1-butanol, 4-amino-2-methyl-1-butanol, 2-aminomethyl-1-butanol, 1-amino-2-methyl-2-butanol, 3-amino-2-methyl-2-butanol, 4-amino-2-methyl-2-butanol, 2-methylamino-2-butanol, 1-amino-3-methyl-1-butanol, 2-amino-3-methyl-1-butanol, 3-amino-3-methyl-1-butanol, 4-amino-3-methyl-1-butanol, 3-aminomethyl-1-butanol, 1-amino-2,2-dimethyl-1-propanol, 3-amino-2,2-dimethyl-1-propanol, 2,2-aminomethylmethyl-1-propanol, 1-amino-3-methyl-2-butanol, 2-amino-3-methyl-2-butanol, 3-amino-3-methyl-2-butanol, 4-amino-3-methyl-2-butanol, 3-methylamino-2-butanol, N,N-methylmethanolamine, N,N-methylethanolamine, N,N-methyl-n-propanolamine, N,N-methyl-isopropanolamine, N,N-methyl-methyl-n-butanolamine, N,N-methyl-methyl-sec-butanolamine, N,N-methyl-methyl-tert-butanolamine, N,N-methylhexanolamine, N,N-methylpentanolamine, N,N-ethylmethanolamine, N,N-ethylethanolamine; N,N-ethylethanolamine, N,N-ethylpropanolamine, N,N-ethylbutanolamine, N,N-ethylhexanolamine, N,N-ethylpentanolamine, N,N-propylmethanolamine, N,N-propylethaholamine N,N-propylethaholamine, N,N-propylpropanolamine, N,N-propylbutanolamine, N,N-propylhexanolamine, N,N-propylpentanolamine, N,N-butylmethanolamine, N,N-butylethanolamine, N,N-butylethanolamine, N,N-butylpropanolamine, N,N-butylbutanolamine, N,N-butylhexanolamine, N,N-butylpentanolamine, N,N-pentylmethanolamine, N,N-pentylethanolamine, N,N-pentyletha-nolamine, N,N-pentylpropanolamine, N,N-pentylbutanolamine, N,N-pentylhexanolamine, N,N-pentylpentanolamine, N,N-hexylmethanolamine, N,N-hexylethanolamine, N,N-hexylethanolamine, N,N-hexylpropanolamine, N,N-hexylbutanolamine, N,N-hexylhexanolamine, N,N-hexylpentanolamine, N,N-dimethylmethanolamine, N,N-methylethylmetanolamine, N,N-diethylmethanolamine, N,N-dimethylethanolamine, N,N-methylethylethanolamine, N,N-diethylethanolamine, triethanolamine, triisopropanolamine, tri-n-propanolamine, tri-n-butanolamine, triisobutanolamine, tri-tert-butanolamine, 2-amino-2-methyl-1,3-propanediolaniline, p-aminophenol, 2-methylamihophehol, N-methylaniline, 2-methylaniline, 3-methylaniline, 4-methylaniline, N,N-dimethylaniline, N,N-dimethylbenzylamine, N,N-dimethylethylaniline, N,N-dimethyl-n-propylaniline, N,N-dimethyl-isopropylaniline, N,N-dimethyl-n-butylaniline, N,N-dimethyl-sec-butylaniline, N,N-dimethyl-tert-butylaniline, N,N-dimethylcyclohexylaniline, N,N-dimethyl-n-hexylaniline, N,N'-dimethyl-n-octylaniline, N,N-dimethyl-n-dodecylaniline, N,N-dimethyl-1-naphthylaniline, 2-anilinoethanol, 2-anilinodiethanol, 4-anilinophenol, 2,6-isopropylaniline, p-isopropanolaniline, 2,6-diisopropanolaniline, o-diisopropanolaniline, p-n-butylaniline, p-sec-butylaniline, p-tert-butylaniline, p-octylanilirie, o-ethylaniline, 2,6-diethylaniline, 2-tert-butylaniline, 2-sec-butylaniline, 2,5-tert-butylaniline, 3,4-ethyleneoxyaniline, 3-amino-1-phenylbutane, diphenylamirieN-ethyl-2,3-xylidine, and p-n-hexylaniline, and are preferably 3-amino-1-propanol, 1-amino-2-propanol, 2-amino-1-propanol, 2-amino-2-methyl-1-propanol, 2-amino-2-methyl-1-propanol, 2-amino-2-methyl-1,3-prop.anediol, and 3-methyl-2-amino-1-butanol, more preferably 2-amino-2-methyl-1-propanol, 2 amino-2-methyl-1,3-propanediol, and 3-methyl-2-amino-1-butanol.

The content of the compound represented by the formula (I) is preferably from 0.01 to 5% by mass, and more preferably from 0.1 to 4% by mass, and particularly preferably from 0.1 to 1% by mass, based on the solid content of the colored photosensitive resin composition. The content of the compound represented by the formula (I) is preferably within the above range because high sensitivity is attained in the photolithography method and the change in exposure before and after storage of the colored photosensitive resin composition decreases furthermore.

The colored photosensitive resin composition of the present invention contains a solvent. The solvent is appropriately selected according to the solubility of a dye, a photo acid initiator, a curing agent, and an alkali-soluble resin, which are contained in the colored photosensitive resin composition, particularly solubility of the dye.

Examples of the solvent include methyl cellosolve, ethyl cellosolve, methyl cellosolve acetate, ethyl cellosolve acetate; diethylene glycol dimethyl ether, ethylene glycol monoisopropyl ether, propylene glycol monomethyl ether, propylene glycol monomethyl ether acetate, N-methyl pyrrolidone, γ-butytolactone, dimethyl sulfoxide, N,N-dimethylformamide, 4-hydroxy-4-methyl-2-pentanone, cyclohexanone, ethyl acetate, n-butyl acetate, ethyl pyruvate, ethyl lactate, and n-butyl lactate, and are preferably γ-butyrolactone, N,N-dimethylformamide, cyclohexanone, ethyl pyruvate, ethyl lactate, n-butyl lactate. These solvents may be used alone or in combination.

The content of the solvent is preferably from 65 to 95% by mass, and more preferably from 71 to 90% by mass, based on the colored photosensitive resin composition.
The content of the solvent is preferably within the above range because uniformity of the film tends to be improved in case of forming a coating film on a substrate using a colored photosensitive resin composition.

To the colored photosensitive resin composition of the present invention, a basic compound (excluding a compound represented by the formula (I)) may be added. The basic compound includes, for example, a basic nitrogen-containing organic compound such as an amine.
It is preferable to add the basic compound because it is possible to improve post exposure properties after exposure, that is, such a property that a size of resist pattern is less likely to change due to deactivation of a photo acid generator, which is caused by allowing the substrate to stand after exposure.
Specific examples of the basic compound include 4-nitroaniline, ethylenediamine, tetramethylenediamine, hexamethylenediamine, 4,4'-diamino-1,2-dipheriylethane, 4,4'-diamino-3,3'-dimethyldiphenylmethane, 4,4'-diamino-3,3'-diethyldiphenylmethane, 4,4'-diamino-3,3',5,5'-tetraethyldiphenylmethane, 8-quinolinol, benzimidazole, 2-hydroxybenzimidozole, 2-hydroxyquinazoline, 4-methoxybenzylidene-4'-n-butylaniline, salicylic acid amide, salicylanilide, 1,8-bis,(N,N-dimethylamino)naphthalene, 1,2-diazine(pyridazine), piperidine, p-amino-benzoic acid, N-acetylethylenediamine, 2-methyl-6-nitroaniline, 5-amino-2-methylphenol, 4-n-butoxyaniline, 3-ethoxy-n-propylamine, 4-methylcyclohexylamine, 4-tert-butylcyclohexylamine, and compounds represented by the formulas (III) to (V):

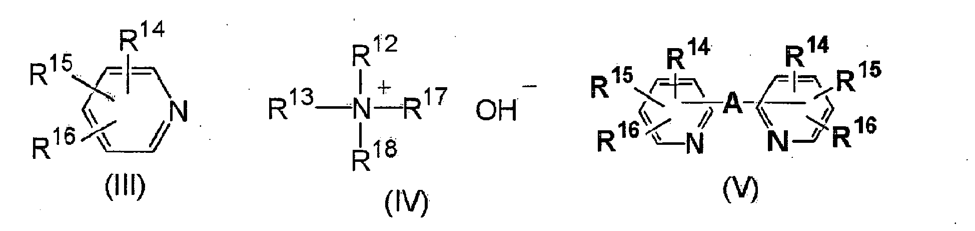

In the formulas (III) to (V), R¹⁴ to R¹⁶ each independently represents a hydrogen atom, a linear alkyl group having 1 to 6 carbon atoms, a branched alkyl group having 3 to 6 carbon atoms, a cycloalkyl group having 5 to 10 carbon atoms, an aryl group having 6 to 12 carbon atoms, or an alkoxy group having 1 to 6 carbon atoms. The linear alkyl group having 1 to 6 carbon atoms, the branched alkyl group having 3 to 6 carbon atoms, the cycloalkyl group having 5 to 10 carbon atoms, the aryl group having 6 to 12 carbon atoms, and the alkoxy group having 1 to 6 carbon atoms each may be independently substituted with a hydroxyl group, an amino group, or an alkoxy group having 1 to 6 carbon atoms. Also, the amino group may be further substituted with an alkyl group having 1 to 4 carbon atoms;
R¹², R¹³, R¹⁷ and R¹⁸ each independently represents a hydrogen atom, a linear alkyl group having 1 to 6 carbon atoms, a branched alkyl group having 3 to 6 carbon atoms, a cycloalkyl group having 5 to 10 carbon atoms, or an aryl group having 6 to 12 carbon atoms. The linear alkyl group, the branched alkyl group, the cycloalkyl group, and the aryl group each may be independently substituted with a hydroxyl group, an amino group, or an alkoxy group having 1 to 6 carbon atoms. The amino group may be substituted with a linear or branched alkyl group having 1 to 4 carbon atoms; and
A represents a single bond, an alkylene group having 1 to 6 carbon atoms, a carbonyl group, an imino group, a sulfide group, an amino group, or a disulfide group.

Examples of the linear alkyl group include a methyl group, ethyl group, n-propyl group, n-butyl group, n-pentyl group, and n-hexyl group, and are preferably methyl group, ethyl group, and n-propyl group.
Examples of the branched alkyl group include an isopropyl group, isobutyl group, sec-butyl group, and tert-butyl group, and are preferably isopropyl group and tert-butyl group.
Examples of the cycloalkyl group include cyclopentyl group, cyclohexyl group, cycloheptyl group, and cyclooctyl group, and are preferably cyclopentyl group and cyclohexyl group.
Examples of the aryl group include a phenyl group and naphthyl group.

Specific examples of the basic compound represented by formula (III) include imidazole, pyridine, 4-methylpyridine, 4-methylimidazole, 2-dimethylaminopyridine, 2-methylaminopyridine, and 1,6-dimethylpyridine.

Examples of the basic compound represented by formula (IV) include tetramethylammonium hydroxide, tetraisopropylammonium hydroxide, tetrabutylammonium hydroxide, tetra-n-hexylammonium hydroxide, tetra-n-octylammonium hydroxide, phenyltrimethylammonium hydroxide, 3-(trifluoromethyl)phenyltrimethylammonium hydroxide, and choline.

Examples of the basic compound represented by formula (V) include bipyridine, 2,2'-dipyridylamine, di-2-pyridylketone, 1,2-di(2-pyridyl)ethane, 1,2-di(4-pyridyl)ethane, 1,3-di(4-pyridyl)propane, 1,2-bis(2-pyridyl)ethylene, 1,2-bis(4-pyridyl)ethylene, 1,2-bis(4-pyridyloxy)ethane, 4,4'-dipyridylsulfide, 4,4'-dipyridyldisulfide, 1,2-bis(4-pyridyl)ethylene, 2,2' - dipicolylamine, and 3,3'-dipicolylamine.

The colored photosensitive resin composition of the present invention may further contain a surfactant as long as the effect of the present invention is hot adversely affected.
Examples of the surfactant include a silicone-based surfactant, fluorine-based surfactant, and silicone-based surfactant having a fluorine atom.
The silicone-based surfactant includes, for example, a surfactant having a siloxane bond. Specific examples thereof include Toray Silicone DC3PA, Toray Silicone SH7PA, Toray Silicone DC11PA, Toray Silicone SH21PA, Toray Silicone SH28PA, Toray Silicone 29SHPA, Toray Silicone SH30PA, and polyether modified silicone oil SH8400 (manufactured by Toray Silicone Co., Ltd.),; KP321, KP322, KP323, KP324, KP326, KP340, KP341 (manufactured by Shin-Etsu Silicone Co., Ltd.); and TSF400, TSF401, TSF410, TSF4300, TSF4440, TSF4445, TSF-4446, TSF4452, and TSF4460 (manufactured by GE Toshiba Silicones Co., Ltd.).
The fluorine-based surfactant includes, for example, a surfactant having a fluorocarbon chain. Specific examples thereof include Fluorad FC430 and Fluorad FC431 (manufactured by Sumitomo 3M, Ltd.); Megafac F142D, Megafac F171, Megafac F172, Megafac F173, Megafac F177, Megafac F183, and Megafac R30 (manufactured by Dainippon Ink and Chemicals, Inc.); Eftop EF301, Eftop EF303, Eftop EF351, and Eftop EF352 (manufactured by Shin-Akita Kasei K.K.); Surflon S381, Surflon S382, Surflon SC101, and Surflon SC105 (manufactured by Asahi Glass Co., Ltd.); E5844 (manufactured by Daikin Finechemical Laboratory), and BM-1000 and BM-1100 (manufactured by BM Chemie).
The silicone-based surfactant having a fluorine atom includes, for example, a surfactant having a siloxane bond and a fluorocarbon chain. Specific examples thereof include Megafac R08, Megafac BL20, Megafac F475, Megafac F477, and Megafac F443 (manufactured by Dainippon Ink and Chemicals, Inc.).
These surfactants may be used alone or in combination.
When the surfactant is used, the amount is preferably 0.0005% by mass or more and 0.6% by mass or less, and more preferably 0.001% by mass or more and 0.5% by mass or less, based on the colored photosensitive resin composition. The content of the surfactant is preferably within the above range because smoothness tends to be further improved in case of coating the colored photosensitive resin composition.

The colored photosensitive resin composition of the present invention may further contain an epoxy resin and an oxetane compound as long as the effect of the present invention is not adversely affected.
Specific examples of the epoxy resin include glycidyl ethers such as bisphenol A type epoxy resin, bisphenol F type epoxy resin, phenol novolak type epoxy resin, cresol novolak type epoxy resin, trisphenolmethane type epoxy resin, brominated epoxy resin, and biphenol type epoxy resin; alicyclic epoxy resins such as 3,4-epoxy-6-methylcyclohexylmethyl-3,4-epoxy-6-methylcyclohexane carboxylate, 3,4-epoxycyclohexylmethyl-3,4-epoxycyclohexane carboxylate, and 1-epoxyethyl-3,4-epoxycyclohexane; glycidyl esters such as phthalic acid diglycidyl ester, tetrahydrophthalic acid diglycidyl ester, and dimer acid glycidyl ester; glycidyl amines such as tetraglycidyl diaminodiphenylmethane; and heterocyclic epoxy resins such as triglycidyl isocyanurate.

Examples of commercially available products of the epoxy resin include Epikote 801 (bisphenol F type epoxy compound, epoxy equivalent: 205 to 225), Epikote 802 (bisphenol F type epoxy compound, epoxy equivalent: 190 to 205), Epikote 807 (bisphenol F type epoxy compound, epoxy equivalent: 160 to 175), Epikote 815 (bisphenol F type epoxy compound, epoxy equivalent: 181 to 191), Epikote 827 (bisphenol A type epoxy compound, epoxy equivalent: 180 to 190), Epikote 828 (bisphenol A type epoxy compound, epoxy equivalent: 184 to 194), Epikote 152 (phenol novolak type epoxy resin, epoxy equivalent: 172 to 178g), Epikote 154 (phenol novolak type epoxy resin, epoxy equivalent: 176 to 180), and Epikote 1.80S65 (orthocresol novolak type epoxy resin, epoxy equivalent: 205 to 220) (all of which are manufactured by Japan Epoxy Resin Co., Ltd.); ESCN195XL (orthocresol novolak type epoxy resin, epoxy equivalent: 195 to 200) (manufactured by Sumitomo Chemical Co., Ltd.); and EP4100 (bisphenol A type epoxy compound, epoxy equivalent: 180 to 200) and EP4340 (bisphenol A type epoxy compound, epoxy equivalent: 205 to 230) (all of which are manufactured by Asahi Denka Kogyo K.K.).

Examples of the oxetane compound include carbonate bisoxetane, xylylene bisoxetahe, adipate bisoxetane, terephthalate bisoxetane, and cyclohexanedicarboxylic acid bisoxetane.

When the epoxy resin or oxetane compound is used, the amount is preferably from 0.01 to 10% by mass, and more preferably from 0.1 to 5% by mass, based on the solid content of the colored photosensitive resin composition. The amount of the epoxy resin or oxetane compound is preferably within the above range because solvent resistance tends to be enhanced.

The colored photosensitive resin composition of the present invention may further contain an ultraviolet absorber as long as the effect of the present invention is not adversely affected.
Examples of the ultraviolet absorber include Adekastab LA-32, Adekastab LA-36, Adekastab LA-36RG, Adekastab 1413, Adekastab LA-51, Adekastab LA-52, Adekastab LA-57, Adekastab LA-62, Adekastab LA-67, Adekastab LA-63P, Adekastab LA-68LD, Adekastab LA-77Y, Adekastab LA-77G, Adekastab LA-82, Adekastab LA-87, Adekastab LA-501, Adekastab LA-502XP, Adekastab LA-503, Adekastab LA-601, Adekastab LA-602, Adekastab LA-603, and Adekastab LA-801 (all of which are manufactured by Asahi Denka Kogyo K.K.); Sumisorb 200, Sumisorb 320, Sumisorb 300, Sumisorb 350, and Sumisorb 340 (a-11. of which are manufactured by Sumitomo Chemical Co., Ltd.); and TINUVIN P, TINUVIN 326, TINUVIN 327, TINUVIN 328, and TINUVIN 234 (all of which are manufactured by Ciba Specialty Chemicals Inc.).
When the ultraviolet absorber is used, the amount is preferably from 0.001 to 10% by mass, and more preferably from 0.01 to 1% by mass, based on the solid content of the colored photosensitive resin composition. The amount of the ultraviolet absorber is preferably within the above range because light resistance tends to be improved.

The colored photosensitive resin composition of the present invention may further contain an antioxidant as long as the effect of the present invention is not adversely affected.
Examples of the antioxidant include Adekastab PEP-4C, Adekastab PEP-8, Adekastab PEP-8W, Adekastab PEP-11C, Adekastab PEP-24G, Adekastab PEP-36, Adekastab PEP-36Z, Adekastab HP-10, Adekastab 2112, Adekastab 2112RG, Adekastab 260, Adekastab 522A, Adekastab 329K, Adekastab 1178, Adekastab 1500, Adekastab C, Adekastab 135A, Adekastab 3010, Adekastab TPP, Adekastab AO-20, Adekastab AO-30, Adekastab AO-40, Adekastab AO-50, Adekastab AO-50RG, Adekastab AO-50F, Adekastab AO-60, Adekastab AO-60G, Adekastab AO-60P, Adekastab AO-70, Adekastab AO-80, Adekastab AO-330, Adekastab A-611, Adekastab A-611RG, Adekastab A-612, Adekastab A-612RG, Adekastab A-613, Adekastab A-613RG, Adekastab AO-51, Adekastab AO-15, Adekastab AQ-18, Adekastab 328, Adekastab AO-37, Adekastab AO-23, Adekastab AO-412S, and Adekastab AO-503A (all of which are manufactured by Asahi Denka Kogyo K.K.); Sumilizer GM, Sumilizer GS, Sumilizer BBM-S, Sumilizer WX-R, Sumilizer WX-RA, Sumilizer WX-RC, Sumilizer NW, Sumilizer GA-80, Sumilizer GP, Sumilizer TPL-R, Sumilizer TPM, Sumilizer TPS, Sumilizer TP-D, Sumilizer MB, and Sumilizer 9A (all of which are manufactured by Sumitomo Chemical Co., Ltd.); and Irganox 1076, Irganox 1010, Irganox 3114, and Irganox 245 (all of which are manufactured by Ciba Specialty Chemicals Inc.).
When the antioxidant is used, the amount is preferably from 0.001 to 10% by mass, and more preferably from 0.01 to 1% by mass, based on the solid content of the colored photosensitive resin composition. The amount of the antioxidant is preferably within the above range because light resistance and heat resistance tend to be improved.

The colored photosensitive resin composition of the present invention may further contain a chelating agent as long as the effect of the present invention is not adversely affected.
Examples of the chelating agent include Adekastab CDA-1, Adekastab CDA-1M, Adekastab CDA-6, Adekastab ZS-27, Adekastab ZS-90, and Adekastab ZS-91 (all of which are manufactured by Asahi Denka Kogyo K.K.); CHELEST MZ-2 and CHELEST MZ-4A (all of which are manufactured by CHELEST CORPORATION); 1,10-phenanthroline, 1,2-phenylenediamine, 1,7-phenanthroline, tripyridine, 2,2'-bipyridine, 2,3,7,8,12,13,17,18-octaethyl-21H,23H-porphyrin, neocuproine, 3,5,6,8-tetramethyl-1,10-phenanthroline, 4,4'-dimethyl-2,2'-biquinoline, 4,4'-diphenyl-2,2'-biquinoline, 4,7-dimethyl-1,10-phenanthroline, p-phenanthroline, and 5-methyl-1,10-phenanthroline.
When the chelating agent is used, the amount is preferably from 0.001 to 10% by mass, and more preferably from 0.01 to 5% by mass, based on the solid content of the colored photosensitive resin composition. The amount of the chelating agent is preferably within the above range because heat resistance tends to be improved.

The colored photosensitive resin composition of the present invention can be prepared by mixing the respective components described above in a solvent. When the colored photosensitive resin composition thus prepared is filtered through a filter having a pore size of about 0.1 µm, undissolved substances having a particle size which is larger than that of the pore size of the filter can be removed and the colored photosensitive resin composition can be uniformly coated on a substrate in case of coating.

When the colored photosensitive resin composition of the present invention is used, it is possible to obtain a color filter comprising pixels each measuring 0.4 to 2.0 µm in film thickness, and about 1.0 to 20 µm in length and width, independently.
To obtain a color filter, similar to a conventional colored photosensitive resin composition, an operation may be conducted using a photolithography method. For example, a coating film made of the colored photosensitive resin composition of the present invention is formed on a support and the coating film is exposed and developed to form a pixel. The support includes, for example, a silicon wafer, transparent glass plate or quartz plate, on which an image sensor (also referred to as a solid-state image pickup device) is formed.

To form the coating film on the support, for example, the colored photosensitive resin composition of the present invention is coated on the support using a coating method such as spin coating method, roll coating method, bar coating method, die coating method, dipping method, casting coating method, roll coating method, slit&spin coating method, or slit coating method, and then a volatile component such as solvent is removed by heating. Thus, the coating film made of the solid content of the colored photosensitive resin composition is formed on the support. After coating, the volatile component is removed by heating at a temperature within a range preferably from 70 to 120°C.

Then, the coating film is exposed. In the exposure process, a mask pattern with a pattern corresponding to the objective pattern is used and the coating film is irradiated with light through the mask pattern. Examples of light ray used in the exposure process include g-ray and i-ray, and the exposure process is conducted using a stepper such as g-ray stepper or i-ray stepper. An exposure dose of light ray in the irradiate area is appropriately selected according to the kind or content of the photosensitizer, the kind or content of the curing agent, and the polystyrene equivalent weight average molecular weight, monomer ratio or content of the alkali-soluble resin. The coating film thus exposed may be heated. The coating film is preferably heated because the curing agent is cured and therefore the mechanical strength of the coating film tends to increase. The heating temperature is preferably from 80 to 150°C.

After the exposure process, the resulting coating film is developed. Similar to the case of using a conventional colored photosensitive resin composition, the coating film is developed by bringing the support, on which the coating film is formed, into contact with a developing solution. As the developing solution, the same developing solution as in case of forming a pattern using a conventional colored photosensitive resin composition can be used. A color filter with the objective pixel pattern formed thereon can be obtained by shaking off the developing solution and washing with water to remove the developing solution. Alternatively, the developing solution is shaken off, followed by rinsing with a rinsing solution and further washing with water. The residue derived from colored photosensitive resin composition remained on the support upon development can be removed by rinsing.

The developing solution is not specifically limited as long as it can dissolve and remove the colored photosensitive resin composition at the exposed area after the exposure process. As the developing solution, an organic solvent and an aqueous alkali solution can be used. As the aqueous alkali solution, an aqueous tetramethylammonium hydroxide solution is used and it may contain a surfactant.

Then, the coating film after developing may be irradiated with ultraviolet ray. When the coating film is irradiated with ultraviolet ray, the photosensitizer remaining in the coating film is decomposed and absorption in the visible range attributed to the photosensitizer preferably disappears.
Furthermore, the mechanical strength of the pixel thus formed can be increased by heating after washing with water. The heating temperature is preferably 160°C or higher and 220°C or lower. The heating temperature is preferably within the above range because the curing agent sufficiently promotes curing, while the dye is not decomposed. Heating may be conducted at the same temperature for a given time, or the temperature may increase, or the temperature may vary stepwisely and maintained at each temperature for a given time.

Thus, a pixel pattern with the objective shape is formed. By repeating a pixel pattern forming process of the color filter, every different color, for example, a three color pixel pattern including a red color pixel, a green color pixel and a blue color pixel is formed on the same support. The order of formation of each color pixel can be optionally changed.

Examples of the image sensor include CCD and CMOS

A camera system can be produced by incorporating the image sensor.

While embodiments of the invention have been described, it should be understood that these are exemplary of the invention and are not to be considered as limiting. The scope of the invention is indicated by the appended claims and all changes which come within the meaning and range of equivalency of the claims are therefore intended to be embraced therein.

### Examples

The present invention will now be described in detail by way of examples, but the present invention is not limited by these examples.

### Synthesis Example 1

19.5 Parts of poly(p-hydroxystyrene) [VP-2500, manufactured by NIPPON SODA CO., LTD., catalogue value: weight average molecular weight of 4,000, dispersion degree of 1.14] and 78 parts of acetone were charged in a reaction vessel equipped with a reflux tube and then dissolved with stirring. In the reaction vessel, 19.2 parts of anhydrous potassium carbonate and 11.8 parts of isopropyl iodide were charged and heated until a reflux state is attained. Subsequently, the reflux state was maintained for 24 hours. 39 Parts of methyl isobutyl ketone was added and the organic layer was washed with 56.1 parts of an aqueous 2 mass% oxalic acid solution, followed by the addition of 58.5 parts of methyl isobutyl ketone and further washing with 44 parts of ion-exchange water. The organic layer washed with ion-exchange water was concentrated until the content reduced to 46 parts and 138 parts of propylene glycol monomethyl ether acetate was added, followed by concentration until the content reduced to 69 parts. The solid content of a concentrated solution thus obtained was measured by a heating weight loss method. As a result, it was 29.91% by mass. ¹H-NMR measurement revealed that 30.6% of hydroxyl groups of poly(p-hydroxystyrene) were isopropyletherified in the resulting resin. The resulting resin is referred to as a resin A.

### Synthesis Example 2

In the same manner as in Synthesis Example 1, except that the amount of anhydrous potassium carbonate is replaced by 9.6 parts and the amount of isopropyl iodide was replaced by 5.9 parts, a resin was synthesized. The solid content of the resulting resin solution was 30.0% by mass. ¹H-NMR measurement revealed that 16.2% of hydroxyl groups of poly(p-hydroxystyrene) were isopropyletherified in the resulting resin. The resulting resin is referred to as a resin B.

### Synthesis Example 3

36.0 parts of poly(p-hydroxystyrene) [MARUKA LYNCUR M, manufactured by Maruzen Petrochemical Co., Ltd., catalogue value: weight average molecular weight of 4,100, dispersion degree of 1.98] and 144 parts of acetone were charged in a reaction vessel and then dissolved with stirring. In the reaction vessel, 20.7 parts of anhydrous potassium carbonate and 9.35 parts of ethyl iodide were charged and heated until a reflux state is attained. Subsequently, the reflux state was maintained for 15 hours. 72 parts of methyl isobutyl ketone were added and the organic layer was washed with 92.8 parts an aqueous 2% oxalic acid solution, followed by the addition of 96 parts of methyl isobutyl ketone and further washing with 64.7 parts of ion-exchange water. The organic layer washed with ion-exchange water was concentrated until the content reduced to 78.3 parts and 187.9 parts of propylene glycol monomethyl ether acetate was added, followed by concentration until the content reduced to 117.4 parts. The solid content of a concentrated solution thus obtained was 30.6% by mass. ¹H-NMR measurement revealed that 19.5% of hydroxyl groups of poly(p-hydroxystyrene) were isopropyletherified in the resin after the reaction. The resulting resin is referred to as a resin C.

### Synthesis Example 4

To a mixture of 50.8 parts of a compound represented by the formula (70) [PIPE-CD, manufactured by Mitsui Chemicals, Inc.], 50.8 parts of methyl isobutyl ketone and 9.5 parts of oxalic acid, 13.8 parts of formalin (containing 37% by mass of formaldehyde) was added dropwise over one hour while stirring at 80°C. After the completion of dropwise addition, the temperature was raised to 91°C and the reaction was conducted at the same temperature for 10 hours. After the completion of the reaction, the reaction mixture was washed with 125 parts of ion-exchange water and 76 parts of methyl isobutyl ketone added, washed with 51 parts of methyl isobutyl ketone and 125 parts of ion-exchange water added, and then dehydrated through distillation to obtain 145.5 parts of a methyl isobutyl ketone solution of a novolak resin. The resulting methyl isobutyl ketone solution was fractionated by adding 133 parts of methyl isobutyl ketone and 363 parts of n-heptane to separate a resin D as a resin layer (liquid). To the resin D, 145.8 parts of ethyl lactate was added to obtain an ethyl lactate solution of the resin D (the content of the resin D is 33% by mass). The resin D had an average molecular weight (GPC, polystyrene equivalent) of 13,300.

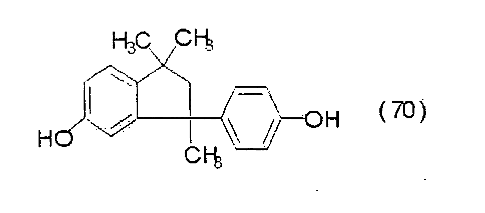

A polystyrene equivalent weight average molecular weight (Mw) of the resin was measured using a GPC method under the following conditions.
Equipment: HLC-8120GPC (manufactured by Tosoh Corporation) Column: TSK-GELG4000HXL+TSK-GELG2000HXL (series connection) Column temperature: 40°C
Solvent: THF
Flow rate: 1.0 mL/min
Injection amount: 50 µL
Detector: RI
Concentration of sample to be measured: 0.6% by mass (solvent: THF)
Calibration standard substance: TSK STANDARD POLYSTYRENE F-40, F-4, F-1, A-2500, A-500 (manufactured by Tosoh Corporation)

### Example 1

17.20 Parts by mass of a dye represented by the formula (30), 17.75 parts by mass of a dye represented by the formula (28), 0.929 parts by mass of α-[(4-toluenesulfonyloxyimino)-4-methoxyphenyl]acetonitrile as a photo acid generator, 10.19 parts by mass (solid content) of a resin A as an alkali-soluble resin, 20.37 parts by mass (solid content) of a resin B as an alkali-soluble resin, 0.22 parts by mass of 2-amino-2-methyl-1-propanol as a compound represented by the formula (I), 23.15 parts by mass of hexamethoxymethylmelamine as a curing agent, 322 parts by mass of ethyl lactate as a solvent, 138 parts by mass of N,N-dimethylformamide as a solvent, and 33 parts by mass of propylene glycol monomethyl ether acetate as a solvent were mixed and then filtered through a membrane filter having a pore size of 0.1 µm to obtain a yellow colored photosensitive resin composition 1.

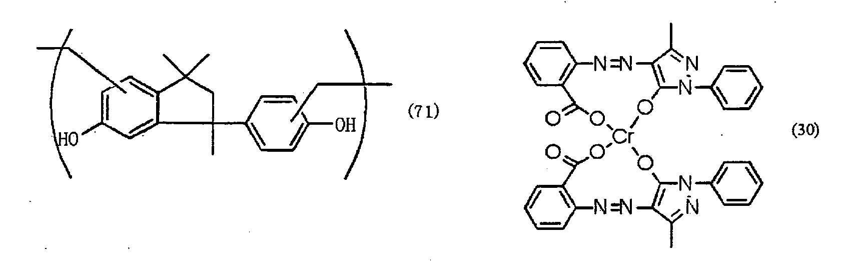

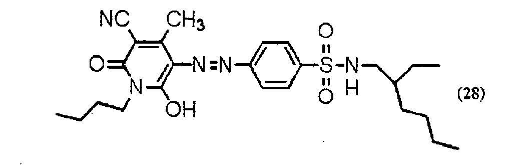

On a silicon wafer, a flattened film forming material containing a polyglycidyl methacrylate resin as a main component was spin coated and then heated at 100°C for one minute to remove a volatile component, thus forming a 0.96 µm thick flattened film. Then, this wafer was heated at 230°C for 2 minutes, thereby curing the flattened film to form a support.
The colored photosensitive resin composition 1 was coated on this support (silicon wafer with a flattened film) using a spin coating method, heated at 100°C for one minute to remove a volatile component, thus forming a coating film having a thickness of 0.66 µm. Using an i-ray stepper [Nikon NSR-1755i7A, manufactured by Nikon Corporation], a mosaic pattern was exposed through a mask pattern having a line width of 2.0 µm while stepwisely varying the exposure within a range from 10 to 6,000 (mJ/cm²).

Then, the resulting coating film after exposure was developed by immersing in a developing solution [aqueous 3 mass% tetramethylammonium hydroxide solution] for 60 seconds.
After the development, the coating film was washed with water, dried, irradiated with ultraviolet ray and then heated at 180°C for 3 minutes to obtain a color filter 1 comprising a yellow pixel formed with a mosaic pattern having a line width of 2.0 µm. The resulting pattern was observed by a scanning electron microscope and the exposure required to obtain a pattern having a line width of 2.0 µm was determined. As a result, the exposure was 700 mJ/cm².
After the same colored photosensitive resin composition 1 was stored at 40°C for one day and stored at 5°C for 30 days, a color filter was formed in the same manner as described above and the exposure required to obtain a pattern having a line width of 2.0 µm was determined. As a result, the exposure was 650 mJ/cm² after storage at 40°C for one day, while the exposure was 700 mJ/cm² after storage at 5°C for 30 days, and thus a change in exposure was found to be small.

### Comparative Example 1

In the same manner as in Example 1, except that 2-amino-2-methyl-1-propanol was not used in Example 1, a yellow colored photosensitive resin composition 2 was obtained. The same operation was conducted, except that coating was conducted to form a film having a thickness of 0.66 µm. Since the colored photosensitive resin composition was completely cured and was not dissolved in a developing solution, a pattern having a line width of 2 µm could not be obtained.

### Example 2

5.7 Parts by mass of a compound represented by the formula (26) as a dye, 10.1 parts by mass of a compound represented by the formula (27) as a dye, 20.9 parts by mass of a compound represented by the formula (32) as a dye, 3.75 parts by mass of α-[(4-toluenesulfonyloxyimino)-4-methoxyphenyl]acetonitrile as a photo acid generator, 9.26 parts by mass (solid content) of a resin D as an alkali-soluble resin, 27.6 parts by mass (solid content) of a resin B as an alkali-soluble resin, 0.738 parts by mass of 2-amino-2-methyl-1-propanol as a compound represented by the formula (I), 21.99 parts by mass of hexamethoxymethylmelamine as a curing agent, 226 parts by mass of ethyl lactate as a solvent, 143 parts by mass of N,N-dimethylformamide as a solvent, and 117 parts by mass of propylene glycol monomethyl ether acetate as a solvent were mixed and filtered through a membrane filter having a pore size of 0.1 µm to obtain a blue colored photosensitive resin composition 3.

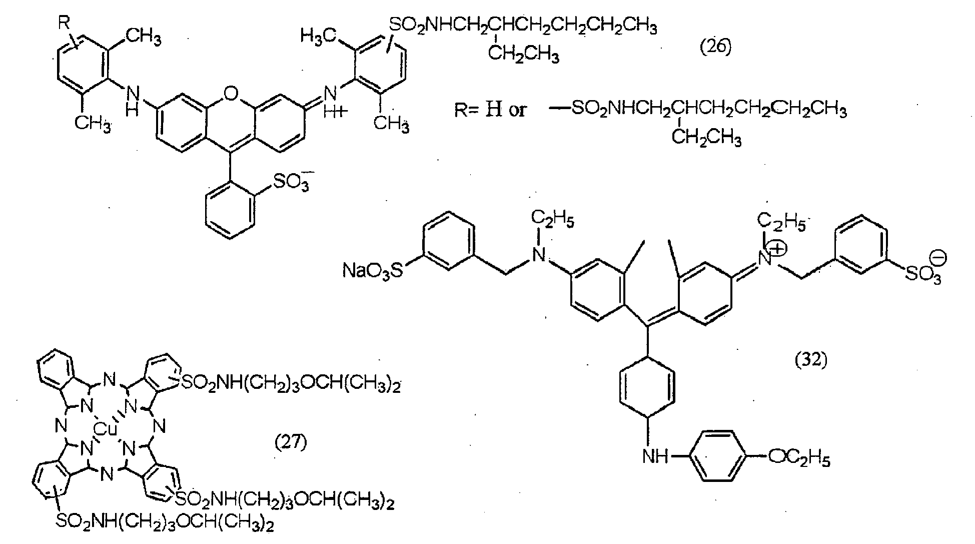

Next, on a silicon wafer, a flattened film forming material containing a polyglycidyl methacrylate resin as a main component was spin coated and then heated at 100°C for one minute to remove a volatile component, thus forming a 0.96 µm thick flattened film. Then, this wafer was heated at 230°C for 2 minutes, thereby curing the flattened film to form a support.
The colored photosensitive resin composition 3 was coated on this support (silicon wafer with a flattened film) using a spin coating method, heated at 100°C for one minute to remove a volatile component, thus forming a coating film having a thickness of 0.92 µm. Using an i-ray stepper [Nikon NSR-2005i9C, manufactured by Nikon Corporation], a mosaic pattern was exposed through a mask pattern having a line width of 2.0 µm while stepwisely varying the exposure within a range from 10 to 6,000 (mJ/cm²).

Then, the resulting coating film after exposure was developed by immersing in a developing solution [aqueous 3 mass% tetramethylammonium hydroxide solution] for 60 seconds.
After the development, the coating film was washed with water, dried, irradiated with ultraviolet ray and then heated at 180°C for 3 minutes to obtain a color filter comprising a blue pixel formed with a mosaic pattern having a line width of 2.0 µm. The resulting pattern was observed by a scanning electron microscope and the exposure required to obtain a pattern having a line width of 2.0 µm was determined. The results are shown in Table 1. Furthermore, after the colored photosensitive resin composition 2 was stored at 40°C for one day and stored at 5°C for 30 days, the same operation as described above was conducted and the exposure required to obtain a pattern having a line width of 2.0 µm was determined. The results are shown in Table 1.

### Example 3

10.5 Parts by mass of a compound represented by the formula (26) as a dye, 8.4 parts by mass of a compound represented by the formulas (33) as a dye, 19.2 parts by mass of a compound represented by the formulas (31) as a dye, 18.4 parts by mass of a compound represented by the formulas (28) as a dye, 4 parts by mass of α-[(4-toluenesulfonyloxyimino)-4-methoxyphenyl]acetonitrile as a photo acid generator, 8.33 parts by mass (solid content) of a resin D as an alkali-soluble resin, 14.6 parts by mass (solid content) of a resin C as an alkali-soluble resin, 0.15 parts by mass of 2-amino-2-methyl-1-propanol as a compound represented by the formula (I), 16.4 parts by mass of hexamethoxymethylmelamine as a curing agent, 142 parts by mass of ethyl lactate as a solvent, 75 parts by mass of N,N-dimethylformamide as a solvent, and 33 parts by mass of propylene glycol monomethyl ether acetate as a solvent were mixed and filtered through a membrane filter having a pore size of 0.1 µm to obtain a red colored photosensitive resin composition 4.
In the same manner as in Example 3, except that the colored photosensitive resin composition 4 was used in place of the colored photosensitive resin composition 3 and the thickness of the film upon spin coating was replaced by 1.21 µm, the exposure required to form a pattern having a line width of 2.0 µm was determined. The results are shown in Table 1.

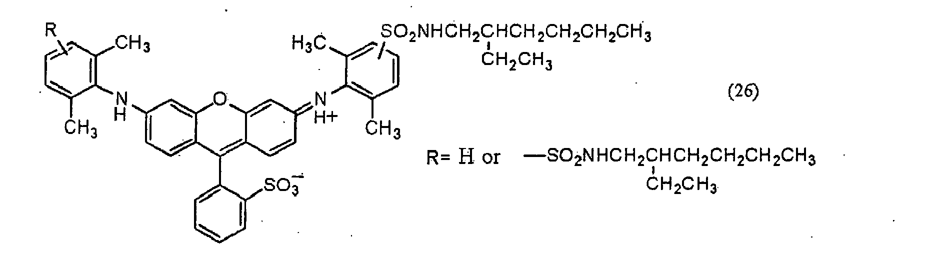

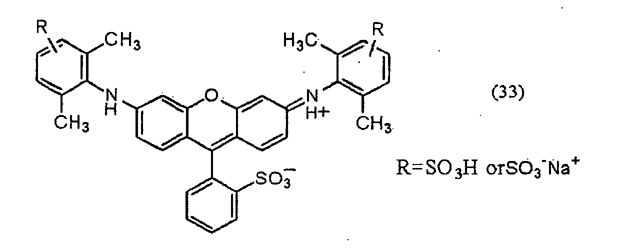

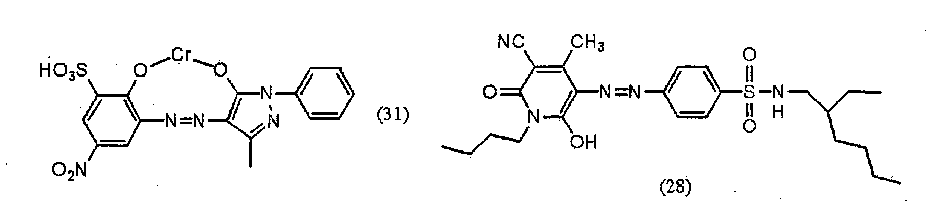

**Table 1**

| Exposure (mJ/cm²) | Example 1 | Example 2 | Example 3 | Comparative Example 1 |
|---|---|---|---|---|
| Immediately after preparation | 700 | 1,515 | 2,250 | 290 |
| After storage at 40°C for 1 day | 650 | 1,515 | 2,250 | Unexposed area was cured |
| After storage at 5°C for 30 days | 700 | 1,500 | 2,150 | Unexposed area was cured |

### Example 4

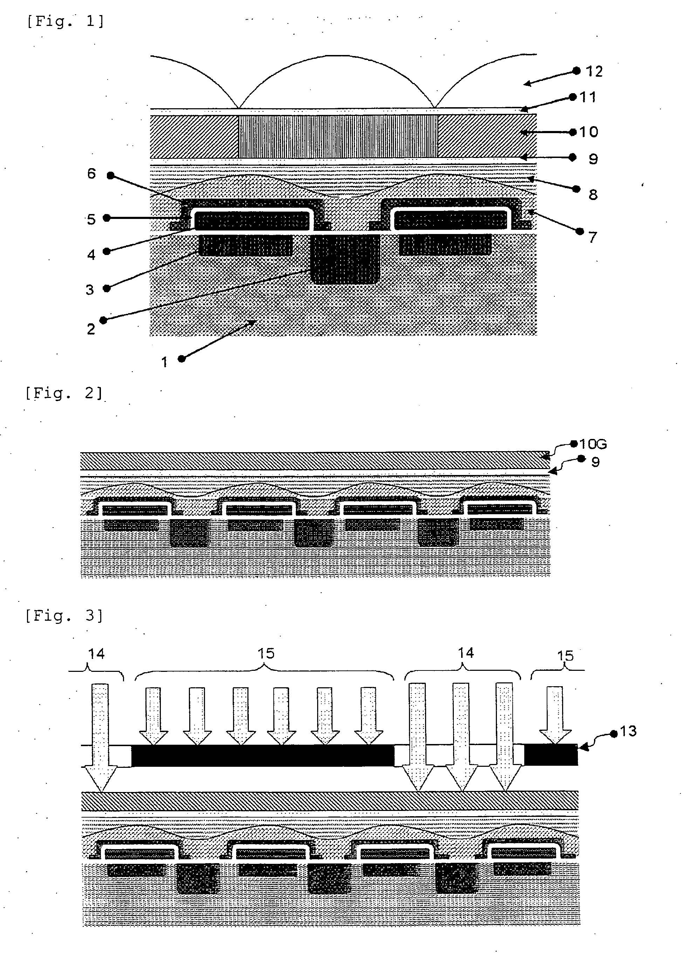

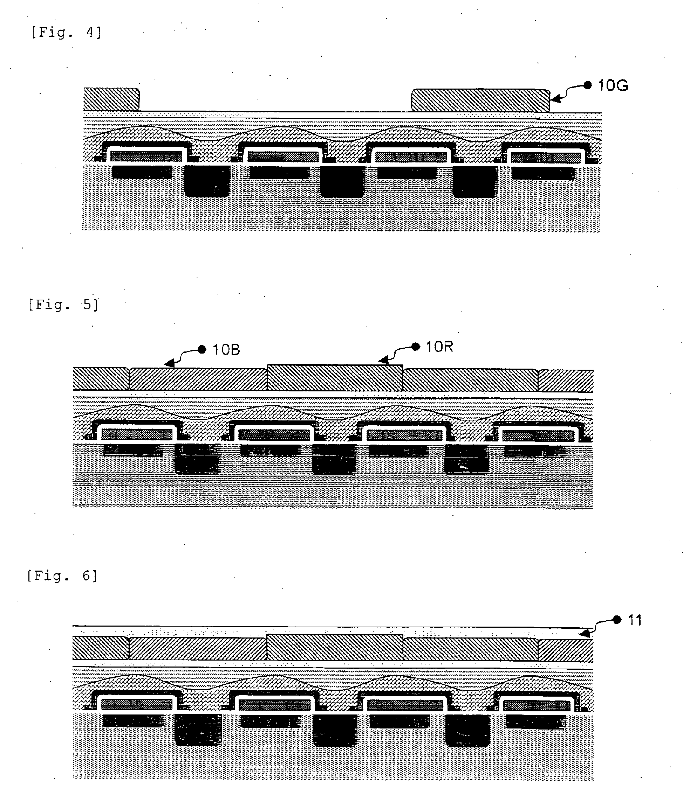

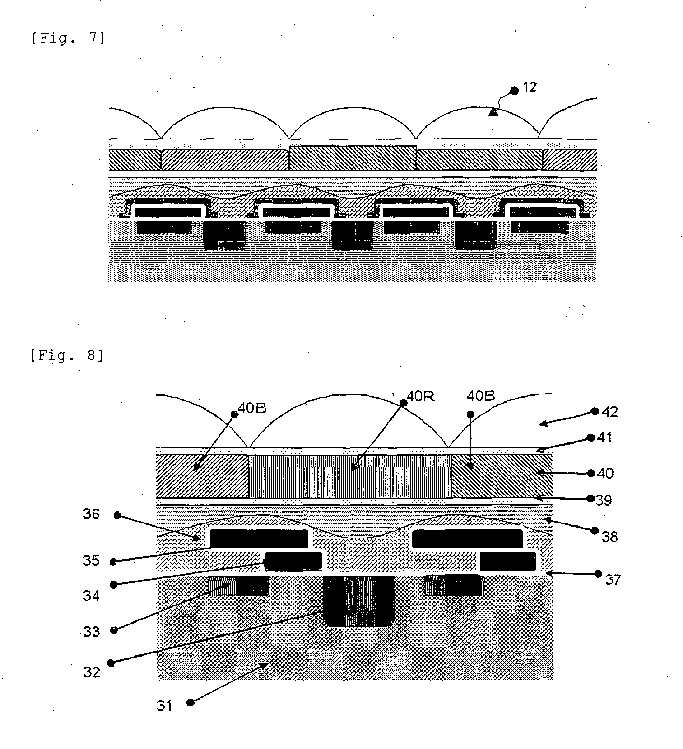

The present invention relates to a technology of forming a color filter array 10 (Fig. 1) in a CCD image sensor. A method for producing a color filter array will now be described with reference to Fig. 2 to Fig. 7.
A photodiode 2 is formed by ion-injecting N-type impurities such as P and As into a portion of the surface of a P-type impurity region in a silicon substrate 1, followed by a heat treatment. Also, a vertical charge transfer section 3 composed of an impurity diffusion layer having an N-type impurity concentration, which is higher than that of the photodiode 2, is formed on the region which exists on the same surface but is different from the portion. This vertical charge transfer section 3 is formed by ion-injecting N-type impurities such as P and As, followed by a heat treatment, and play a role of a vertical Burried Channel layer (CCD) capable of transferring charges generated when the photodiode 2 receives incident light.
In this example, the impurity region of the silicon substrate 1 serves as a P-type impurity layer, while the photodiode 2 and the vertical charge transfer section 3 serve as an N-type impurity layer. Alternatively, the impurity region of the silicon substrate 1 can serve as an N-type impurity layer, while the photodiode 2 and the vertical charge transfer section 3 can serve as a P-type impurity layer.
On the silicon substrate 1, the photodiode 2 and the vertical charge transfer section 3, a vertical charge transfer electrode 4 composed of polySi, tungsten, tungsten silicide, Al, and Cu is formed through an insulation film made of SiO₂ or SiO₂SiN/SiO₂. The vertical charge transfer electrode 4 plays a role of a transfer gate capable of transferring charges generated in the photodiode 2 to the vertical charge transfer section 3, and a role of a transfer electrode capable of transferring charges transferred to the vertical charge transfer section 3 to the vertical direction of a chip.
Above and at the side of the vertical charge transfer electrode 4, a light shielding layer 6 is formed through an insulation film 5 made of SiO₂ or SiN. The light shielding film 6 is made of tungsten, tungsten silicide, or metal such as Al or Cu, and play a role of preventing incident light from entering into the vertical charge transfer electrode 4 and the vertical charge transfer section 3. Above the photodiode 2 out of the side of the light shielding film 6, a light shielding film 6 is provided with a projecting section, thereby making it possible to prevent incident light from leaking into the vertical charge transfer section 3.
Above the light shielding film 6, a BPSG film 7 and a P-SiN film 8 are formed. An interface between the BPSG film 7 and the P-SiN film 8 is formed in the form of curving downward above the photodiode 2, and plays a role of an interlayer lens for efficiently bringing incident light to the photodiode 2.
For the purpose of flattening irregular portions other than the surface of the P-SiN film 8 or the pixel area, a flattened film layer 9 is formed (Fig. 2).
Then, a colored photosensitive resin composition for forming a green color pixel pattern among colored photosensitive resin compositions of the present invention is coated on the substrate (10G) (Fig. 2), and then projection exposure of a pattern is conducted through a photomask 13 (Fig. 3). Subsequently, the unexposed area 15 which is soluble in a developing solution, excluding the exposed area 14 which is made insoluble in a developing solution as a result of the exposure of the coated colored photosensitive resin composition, is dissolved with the developing solution to form a pattern. Then, the pattern is cured by heating to form a desired green color pixel pattern 10G (Fig. 4).
Then, this process is repeated with respect to a red color pixel pattern 10R and a blue color pixel pattern 10B to form a three color pixel pattern on the same plane of an image sensor forming substrate (Fig. 5).
Furthermore, for the purpose of flattening irregular portions of the color filter array, a flattened film 11 is formed (Fig. 6). Then, a microlens 12 for efficiently collecting light made incident into the photodiode 2 of the image sensor is formed (Fig. 7) to form a CCD image sensor and a camera system.

### Example 5

The present invention relates to a technology of forming a color filter array 40 (Fig. 8) in a CMOS image sensor. A method for producing a color filter array is the same as in the description in Example 4.
A photodiode 32 is formed by forming a P well 31 on a silicon substrate and ion-injecting N-type impurities such as P and As into a portion of the surface of the P well, followed by a heat treatment. Also, an impurity diffusion layer 33 having an N-type impurity concentration, which is higher than that of the photodiode 32, is formed on the region which exists on the surface of the P well 31 of the silicon substrate but is different from the portion. This impurity diffusion layer 33 is formed by ion-injecting N-type impurities such as P and As, followed by a heat treatment, and play a role of a suspended diffusion layer capable of transferring charges generated when the photodiode 32 receives incident light.
In this example, the well 31 serves as a P-type impurity layer, while the photodiode 32 and the impurity diffusion layer 33 serve as an N-type impurity layer. Alternatively, the well 31 can serve as an N-type impurity layer, while the photodiode 32 and the impurity diffusion layer 33 can serve as a P-type impurity layer.
On the P well 31, the photodiode 32 and the impurity diffusion layer 33, an insulation film 37 made of SiO₂ or SiO₂/SiN/SiO₂ is formed. On the insulation film 34, an electrode 34 made of polySi, tungsten, tungsten silicide, Al, and Cu is formed. The electrode 34 plays as role of a gate of a gate MOS transistor. In this example, it plays a role of a transfer gate capable of transferring charges generated in the photodiode 32 to the impurity diffusion layer 33.
Above the electrode 34, a wiring layer 35 is formed through an insulation film 37 made of SiO₂ or SiN. Above the wiring layer 35, a BPSG film 36 and a P-SiN film 38 are formed. An interface between the BPSG film 36 and the P-SiN film 38 is formed in the form of curving downward over the photodiode 32, and plays a role of an interlayer lens for efficiently bringing incident light to the photodiode 32.
For the purpose of flattening irregular portions other than the surface of the P-SiN film 38 or the pixel area, a flattened film layer 39 is formed.
Then, a colored photosensitive resin composition for forming a green color pixel pattern among colored photosensitive resin compositions of the present invention is coated on the substrate (40G), and then projection exposure of a pattern is conducted through a photomask. Subsequently, the unexposed area which is soluble in a developing solution, excluding the exposed area which is made insoluble in a developing solution as a result of the exposure of the coated colored photosensitive resin composition, is dissolved with the developing solution to form a pattern. Then, the pattern is cured by heating to form a desired green color pixel pattern 40G.
Then, this process is repeated with respect to a red color pixel pattern 40R and a blue color pixel pattern 40B to form a three color pixel pattern on the same plane of an image sensor forming substrate.
Furthermore, for the purpose of flattening irregular portions of the color filter array, a flattened film 41 is formed. Then, a microlens 42 for efficiently collecting light made incidient into the photodiode 32 of the image sensor is formed to form a CCD image sensor and a camera system.

### Example 6

A camera system of the present invention is shown in Fig. 8. A method for producing a color filter array is the same as in the description in Example 4.
Incident light is made incident into an image sensor 52 through a lens 51. An on-chip lens 12 or 42 and a color filter array 10 or 40 are formed on the light incident surface side of the image sensor 52. A signal output from the image pickup device 52 is signal processed by a signal processing circuit 53 and then out put from a camera.
The image sensor 52 is driven by a device drive circuit 55. The device drive circuit 55 is capable of inputting setting of a still picture mode and a moving picture mode by a mode setting section 54.

The colored photosensitive resin composition of the present invention is preferably used for the formation of a color filter for image sensor such as CCD or CMOS sensor, and an image sensor preferably comprises a color filter, and a camera system preferably comprises the image sensor.
The major embodiments and the preferred embodiments of the present invention are listed below.
[1] A colored photosensitive resin composition comprising a dye, a photo acid generator, a curing agent, an alkali-soluble resin, a solvent, and a compound represented by the formula (I) : 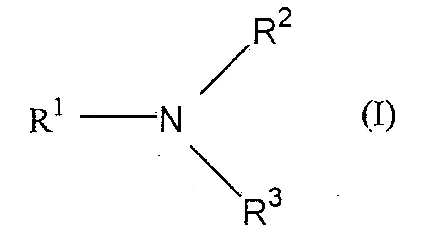 in the formula (I), R¹ to R³ each independently represents a hydrogen atom, a linear alkyl group having 1 to 6 carbon atoms, a branched alkyl group having 3 to 12 carbon atoms, a cycloalkyl group having 3 to 6 carbon atoms or an aryl group having 6 to 12 carbon atoms, and a hydrogen atom on the linear alkyl group having 1 to 6 carbon atoms, a hydrogen atom on the branched alkyl group having 3 to 12 carbon atoms, a hydrogen atom on the cycloalkyl group and a hydrogen atom on the aryl group may be substituted with a hydroxyl group, provided that at least one of R¹ to R³ represents a group other than a hydrogen atom.
[2] The colored photosensitive resin composition according to [1], wherein the content of the compound represented by the formula (1) is from 0.01 to 1% by mass based on the solid content of the colored photosensitive resin composition.
[3] A color filter produced using the colored photosensitive resin composition according to [1] or [2].
[4] An image sensor comprising the color filter according to [3].
[5] A camera system comprising the image sensor according to [4].

## Claims

1. A colored photosensitive resin composition comprising a dye, a photo acid generator, a curing agent, an alkali-soluble resin, a solvent, and a compound represented by the formula (I): 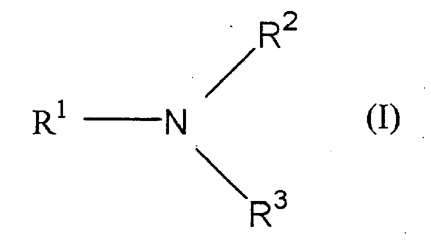 wherein , R¹ to R³ each independently represents a hydrogen atom, a linear alkyl group having 1 to 6 carbon atoms, a branched alkyl group having 3 to 12 carbon atoms, a cycloalkyl group having 3 to 6 carbon atoms or an aryl group having 6 to 12 carbon atoms, and a hydrogen atom on the linear alkyl group having 1 to 6 carbon atoms, a hydrogen atom on the branched alkyl group having 3 to 12 carbon atoms, a hydrogen atom on the cycloalkyl group and a hydrogen atom on the aryl group may be substituted with a hydroxyl group, provided that at least one of R¹ to R³ represents a group other than a hydrogen atom.

2. The colored photosensitive resin composition according to claim 1, wherein the content of the compound represented by the formula (I) is from 0.01 to 1% by mass based on the solid content of the colored photosensitive resin composition.

3. A color filter produced using the colored photosensitive resin composition according to claim 1 or 2.

4. An image sensor comprising the color filter according to claim 3.

5. A camera system comprising the image sensor according' to claim 4.
